# EUROPEAN PATENT SPECIFICATION

(11) **EP 4 459 967 B1**
(45) Date of publication and mention of the grant of the patent: **15.07.2026**
(21) Application number: 23767009.6
(22) Date of filing: 12.01.2023
(51) Int. Cl.: H04M 1/02, H05K 1/14, H02J 50/10, H05K 1/02, H05K 7/20, G06F 1/16

(54) **ELECTRONIC DEVICE INCLUDING STRUCTURE FOR REDUCING DISTANCE BETWEEN BATTERY AND POWER MANAGEMENT CIRCUIT**
ELEKTRONISCHE VORRICHTUNG MIT STRUKTUR ZUR VERRINGERUNG DES ABSTANDS ZWISCHEN BATTERIE UND LEISTUNGSVERWALTUNGSSCHALTUNG
DISPOSITIF ÉLECTRONIQUE COMPRENANT UNE STRUCTURE PERMETTANT DE RÉDUIRE LA DISTANCE ENTRE LA BATTERIE ET LE CIRCUIT DE GESTION DE LA PUISSANCE

(30) Priority: 11.03.2022 KR 20220030775; 13.07.2022 KR 20220086598
(43) Date of publication of application: 06.11.2024
(73) Proprietor: Samsung Electronics Co., Ltd, Suwon-si, Gyeonggi-do 16677 (KR)
(72) Inventor: CHOI, Nakhyun, Suwon-si, Gyeonggi-do 16677 (KR); CHO, Baekeun, Suwon-si, Gyeonggi-do 16677 (KR); KWAK, Myunghoon, Suwon-si, Gyeonggi-do 16677 (KR); KIM, Hyunsuk, Suwon-si, Gyeonggi-do 16677 (KR); PARK, Sanghyuk, Suwon-si, Gyeonggi-do 16677 (KR); SEO, Soohyun, Suwon-si, Gyeonggi-do 16677 (KR); LEE, Wonho, Suwon-si, Gyeonggi-do 16677 (KR); CHO, Joongyeon, Suwon-si, Gyeonggi-do 16677 (KR); LEE, Junghyeob, Suwon-si, Gyeonggi-do 16677 (KR); HONG, Hyunju, Suwon-si, Gyeonggi-do 16677 (KR)
(74) Representative: Appleyard Lees IP LLP
(86) International application number: PCT/KR2023/000592
(87) International publication number: WO 2023/171904

(56) References cited:
- WO-A1-2022/014904
- KR-A- 20190 118 058
- KR-A- 20200 024 500
- KR-A- 20200 102 256
- KR-A- 20210 022 921
- KR-A- 20210 116 542
- US-A1- 2022 019 261
- US-A1- 2022 053 653
- US-A1- 2023 145 655

## Description

### [Technical Field]

Various embodiments relate to an electronic device including a structure for reducing a distance between a battery and a power management circuit.

### [Background Art]

In order for a user to easily carry an electronic device, the electronic device may be miniaturized. Although the electronic device is miniaturized, a need for an electronic device in which a size of a display for displaying contents may be changed is increasing so that the user may be provided with various contents through the electronic device. For example, the electronic device may include a foldable device in which a size of a display exposed to the outside of the electronic device is changed as one housing among a plurality of housings is folded with respect to another one housing. For another example, the electronic device may include a rollable device in which the size of the display exposed to the outside of the electronic device is changed as the one housing among the plurality of housings slides with respect to the other housing. US 2022/0019261 A1 describes an electronic device that includes a first housing including a first space and including a first support member. WO 2022/014904 A1 describes an electronic device comprising a first housing which includes a first space formed through a first side surface, a second side surface extending in the direction perpendicular to the first side surface, and a third side surface extending from the second side surface to be parallel with the first side surface. US 2022/0053653 A1 describes a device and a method for an antenna of an electronic device that includes a rollable display. KR 2021-0116542 A describes a mobile terminal that includes a first frame, and a second frame slidably-movable in a first direction. KR 2020-0024500 A describes a foldable electronic device having wireless communication circuits distributed with respect to a folding axis. KR 2019-0118058 A describes an electronic device. KR 2020-0102256 A describes an electronic device including a logic circuit for determining a connection state of a connector. KR 2021-0022921 A describes an electronic device including a first side surface member, a sliding unit, a sliding operation control unit, and an auxiliary side surface member.

### [Disclosure]

### [Technical Problem]

As an electronic device is miniaturized for user portability and a mounting space becomes insufficient, each of the various electronic components in the electronic device may be disposed in a different housing. For example, a battery may be disposed in one housing among a plurality of housings, and power management circuitry that manages power supplied to the electronic components may be disposed in another one housing among the plurality of housings. In order for power of the battery to be transmitted to the electronic component, the power needs to go through the power management circuitry before being transmitted from the battery to the electronic component. In case that the battery and the power management circuitry are disposed in different housings, respectively, as the distance between the battery and the power management circuitry increases, power loss may occur. Since performance of the electronic device deteriorates when the power loss occurs, the electronic device may need a structure for reducing the power loss occurring between the power management circuitry and the battery to prevent the performance deterioration.

A technical problem intended to be achieved in this document is not limited to a technical problem mentioned above, and other technical problems not mentioned herein will be clearly understood by a person with ordinary knowledge in a technical field to which the present invention belongs from the following description.

### [Technical Solution]

The invention is set out in the appended claims.

### [Advantageous Effects]

An electronic device according to an embodiment may prevent deterioration in operation performance due to power loss that may occur in case that a distance between a plurality of housings increases, by disposing a battery and power management circuitry in the same housing.

An effect that can be obtained from the present disclosure is not limited to the effects mentioned above, and any other effects not mentioned herein will be clearly understood by a person with ordinary knowledge in a technical field to which the present disclosure belongs from the following description.

### [Description of the Drawings]

FIG. 1 is a block diagram of an electronic device in a network environment according to various embodiments.
FIG. 2 is a block diagram of a power management module and a battery according to various embodiments.
FIG. 3A is a front view of a first state of an electronic device according to an embodiment.
FIG. 3B is a rear view of a first state of an electronic device according to an embodiment.
FIG. 3C is a front view of a second state of an electronic device according to an embodiment.
FIG. 3D is a rear view of a second state of an electronic device according to an embodiment.
FIG. 4A is an exploded perspective view of an electronic device according to an embodiment.
FIG. 4B is a cross-sectional view illustrating an example of an electronic device cut along A-A' of FIG. 3A according to an embodiment.
FIG. 5A is a rear view of a first state of an electronic device in a state in which a book cover is removed, according to an embodiment.
FIG. 5B is a rear view of a second state of an electronic device in a state in which a book cover is removed, according to an embodiment.
FIG. 6A is a rear view of a first state of an electronic device in a state in which a book cover is removed, according to an embodiment.
FIG. 6B is a cross-sectional view illustrating an example in which an electronic device is cut along B-B' of FIG. 6A in a state in which a bracket is removed, according to an embodiment.
FIG. 7A is a rear view of a first state of an electronic device according to an embodiment.
FIG. 7B is a rear view of a second state of an electronic device according to an embodiment.
FIG. 8 is a rear view of an electronic device in a state in which a book cover is removed, according to an embodiment.
FIG. 9 is a rear view of an electronic device in a state in which a book cover is removed, according to an embodiment.
FIG. 10A is a cross-sectional view illustrating an example of an electronic device cut along C-C' of FIG. 6A, according to an embodiment.
FIG. 10B is a cross-sectional view illustrating an example of an electronic device cut along D-D' of FIG. 6A, according to an embodiment.
FIG. 11A is a front view of a frame cover of an electronic device according to an embodiment.
FIG. 11B is a rear view of a frame cover of an electronic device according to an embodiment.
FIG. 12 is a cross-sectional view illustrating another example of an electronic device cut along C-C' of FIG. 6A, according to an embodiment.

### [Mode for Invention]

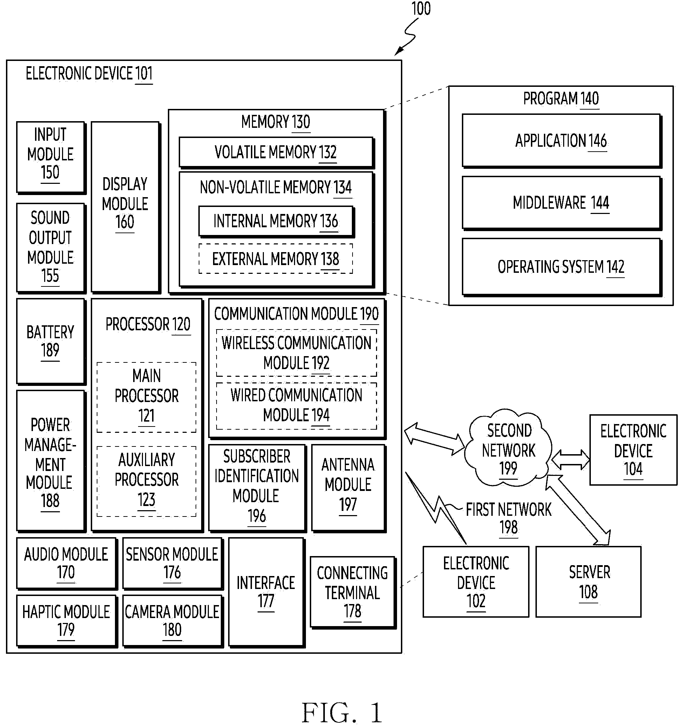

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or loT-related technology.

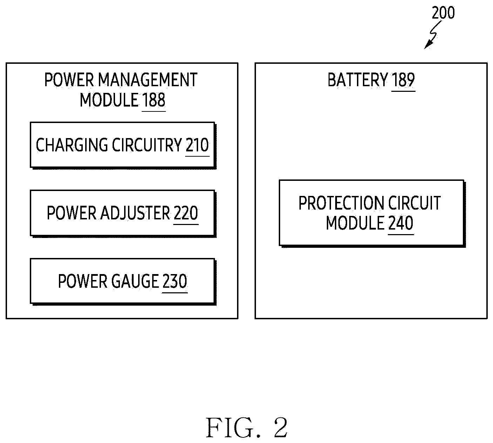

Fig. 2 is a block diagram 200 illustrating the power management module 188 and the battery 189 according to various embodiments.

Referring to Fig. 2, the power management module 188 may include charging circuitry 210, a power adjuster 220, or a power gauge 230. The charging circuitry 210 may charge the battery 189 by using power supplied from an external power source outside the electronic device 101. According to an embodiment, the charging circuitry 210 may select a charging scheme (e.g., normal charging or quick charging) based at least in part on a type of the external power source (e.g., a power outlet, a USB, or wireless charging), magnitude of power suppliable from the external power source (e.g., about 20 Watt or more), or an attribute of the battery 189, and may charge the battery 189 using the selected charging scheme. The external power source may be connected with the electronic device 101, for example, directly via the connecting terminal 178 or wirelessly via the antenna module 197.

The power adjuster 220 may generate a plurality of powers having different voltage levels or different current levels by adjusting a voltage level or a current level of the power supplied from the external power source or the battery 189. The power adjuster 220 may adjust the voltage level or the current level of the power supplied from the external power source or the battery 189 into a different voltage level or current level appropriate for each of some of the components included in the electronic device 101. According to an embodiment, the power adjuster 220 may be implemented in the form of a low drop out (LDO) regulator or a switching regulator. The power gauge 230 may measure use state information about the battery 189 (e.g., a capacity, a number of times of charging or discharging, a voltage, or a temperature of the battery 189).

The power management module 188 may determine, using, for example, the charging circuitry 210, the power adjuster 220, or the power gauge 230, charging state information (e.g., lifetime, over voltage, low voltage, over current, over charge, over discharge, overheat, short, or swelling) related to the charging of the battery 189 based at least in part on the measured use state information about the battery 189. The power management module 188 may determine whether the state of the battery 189 is normal or abnormal based at least in part on the determined charging state information. If the state of the battery 189 is determined to abnormal, the power management module 188 may adjust the charging of the battery 189 (e.g., reduce the charging current or voltage, or stop the charging). According to an embodiment, at least some of the functions of the power management module 188 may be performed by an external control device (e.g., the processor 120).

The battery 189, according to an embodiment, may include a protection circuit module (PCM) 240. The PCM 240 may perform one or more of various functions (e.g., a pre-cutoff function) to prevent a performance deterioration of, or a damage to, the battery 189. The PCM 240, additionally or alternatively, may be configured as at least part of a battery management system (BMS) capable of performing various functions including cell balancing, measurement of battery capacity, count of a number of charging or discharging, measurement of temperature, or measurement of voltage.

According to an embodiment, at least part of the charging state information or use state information regarding the battery 189 may be measured using a corresponding sensor (e.g., a temperature sensor) of the sensor module 176, the power gauge 230, or the power management module 188. According to an embodiment, the corresponding sensor (e.g., a temperature sensor) of the sensor module 176 may be included as part of the PCM 240, or may be disposed near the battery 189 as a separate device.

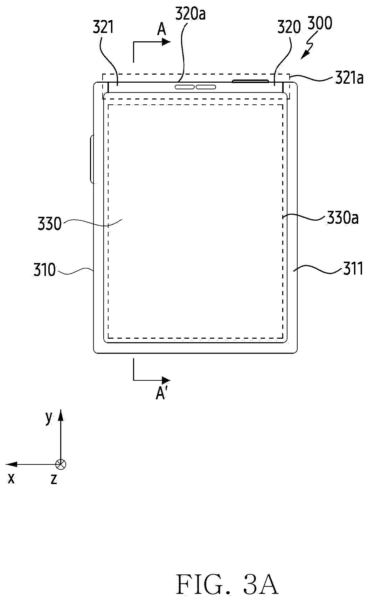

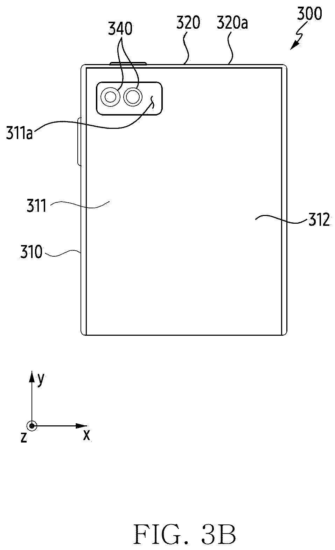

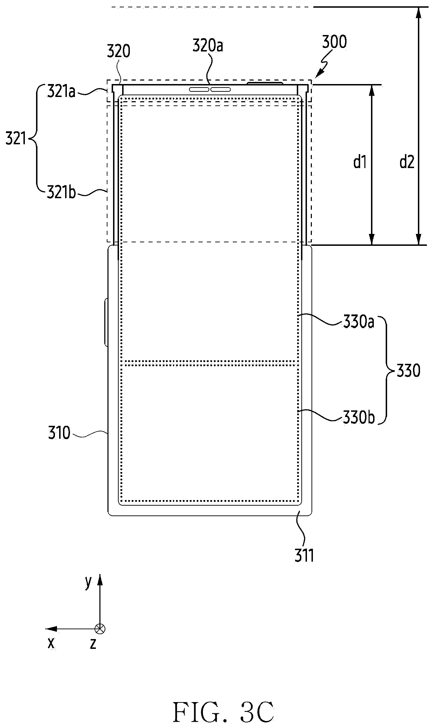

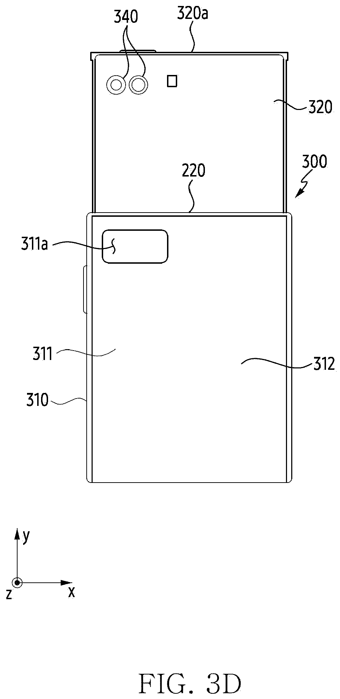

FIG. 3A is a front view of a first state of an electronic device according to an embodiment, FIG. 3B is a rear view of a first state of an electronic device according to an embodiment, FIG. 3C is a front view of a second state of an electronic device according to an embodiment, and FIG. 3D is a rear view of a second state of an electronic device according to an embodiment.

Referring to FIGS. 3A, 3B, 3C, and 3D, an electronic device 300 (e.g., an electronic device 101 of FIG. 1) according to an embodiment may include a first housing 310, a second housing 320, a display 330 (e.g., a display module 160 of FIG. 1), and a camera 340 (e.g., a camera module 180 of FIG. 1). According to an embodiment, the second housing 320 may be slidable with respect to the first housing 310. For example, the second housing 320 may move in a range within a designated distance along a first direction (e.g., +y direction) with respect to the first housing 310. When the second housing 320 moves along the first direction, a distance between the first housing 310 and a lateral surface 320a of the second housing 320 facing the first direction may increase. For another example, the second housing 320 may move in a range within a designated distance along a second direction (e.g., -y direction) opposite the first direction with respect to the first housing 310. When the second housing 320 moves along the second direction, the distance between the first housing 310 and the lateral surface 320a of the second housing 320 facing the first direction may decrease. According to an embodiment, the second housing 320 may linearly reciprocate with respect to the first housing 310 by sliding with respect to the first housing 310. For example, at least a portion of the second housing 320 may be insertable into the first housing 310 or may be extractable from the first housing 310.

According to an embodiment, the electronic device 300 may be referred to as a "slidable electronic device" as the second housing 320 is designed to be slidable with respect to the first housing 310. According to an embodiment, the electronic device 300 may be referred to as a "rollable electronic device" as at least a portion of the display 330 is designed to be rolled in the second housing 320 (or the first housing 310) based on the slide movement of the second housing 320.

According to an embodiment, the first state of the electronic device 300 may be defined as a state (e.g., a contracted state, or a slide-in state) in which the second housing 320 has moved in the second direction. For example, in the first state of the electronic device 300, the second housing 320 may be movable in the first direction, but may not be movable in the second direction. In the first state of the electronic device 300, the distance between the first housing 310 and the lateral surface 320a of the second housing 320 may increase as the second housing 320 moves, but may not decrease. For another example, in the first state of the electronic device 300, a portion of the second housing 320 may be extractable into the first housing 310, but may not be insertable. According to an embodiment, the first state of the electronic device 300 may be defined as a state in which a second area 330b of the display 330 is not visually exposed from the outside of the electronic device 300. For example, in the first state of the electronic device 300, the second area 330b of the display 330 may be located inside an internal space (not illustrated) of the electronic device 300 formed by the first housing 310 and/or the second housing 320, and may not be visible from the outside of the electronic device 300.

According to an embodiment, the second state of the electronic device 300 may be defined as a state (e.g., an expanded state, or a slide-out state) in which the second housing 320 has moved in the first direction. For example, in the second state of the electronic device 300, the second housing 320 may be movable in the second direction, but may not be movable in the first direction. In the second state of the electronic device 300, the distance between the first housing 310 and the lateral surface 320a of the second housing 320 may decrease as the second housing 320 moves, but may not increase. For another example, in the second state of the electronic device 300, a portion of the second housing 320 may be insertable into the first housing 310, but may not be extractable from the first housing 310. According to an embodiment, the second state of the electronic device 300 may be defined as a state in which the second area 330b of the display 330 is visually exposed from the outside of the electronic device 300. For example, in the second state of the electronic device 300, the second area 330b of the display 330 may be extracted from the internal space of the electronic device 300 and visible from the outside of the electronic device 300.

According to an embodiment, in case that the second housing 320 moves from the first housing 310 in the first direction, at least a portion of the second housing 320 and/or the second area 330b of the display 330 may be extracted from the first housing 310 by an extraction length d1 corresponding to a movement distance of the second housing 320. According to an embodiment, the second housing 320 may reciprocate within a designated distance d2. According to an embodiment, the extraction length d1 may have a size of approximately 0 to the designated distance d2.

According to an embodiment, the state of the electronic device 300 may be switchable between the second state and/or the first state, either by a manual operation by a user or by an automatic operation by a driving module (not illustrated) disposed inside the first housing 310 or the second housing 320. According to an embodiment, an operation of the driving module may be triggered based on a user input. According to an embodiment, the user input for triggering the operation of the driving module may include a touch input, a force touch input, and/or a gesture input through the display 330. According to another embodiment, the user input for triggering the operation of the driving module may include a sound input (voice input) or an input of a physical button exposed to the outside of the first housing 310 or the second housing 320. According to an embodiment, the driving module may be driven in a semi-automatic manner in which an operation is triggered when a manual operation by an external force of the user is detected.

According to an embodiment, the first state of the electronic device 300 may be referred to as a first shape, and the second state of the electronic device 300 may be referred to as a second shape. For example, the first shape may include a normal state, a reduced state, or a closed state, and the second shape may include an open state. According to an embodiment, the electronic device 300 may form a third state (e.g., an intermediate state) that is a state between the first state and the second state. For example, the third state may be referred to as the third shape, and the third shape may include a free stop state.

According to an embodiment, the display 330 may be visible (or viewable) from the outside through the front direction (e.g., -z direction) of the electronic device 300 so that visual information may be displayed to the user. For example, the display 330 may include a flexible display. According to an embodiment, the display 330 may be disposed in the second housing 320 and may be extracted from the internal space (not illustrated) of the electronic device 300 or may be inserted into the internal space of the electronic device 300 according to the movement of the second housing 320. The internal space of the electronic device 300 may mean a space in the first housing 310 and the second housing 320 formed by coupling of the first housing 310 and the second housing 320. For example, in the first state of the electronic device 300, at least a portion of the display 330 may be rolled into the internal space of the electronic device 300 and inserted. When the second housing 320 moves in the first direction in a state that at least a portion of the display 330 is inserted into the internal space of the electronic device 300, at least a portion of the display 330 may be extracted from the internal space of the electronic device 300. For another example, when the second housing 320 moves in the second direction, at least a portion of the display 330 may be inserted into the internal space of the electronic device 300 by being rolled into the electronic device 300. As at least a portion of the display 330 is extracted or inserted, the area of the display 330 visible from the outside of the electronic device 300 may be expanded or reduced. According to an embodiment, the display 330 may include a first area 330a and the second area 330b.

According to an embodiment, the first area 330a of the display 330 may mean an area of the display 330 that may be fixedly visible outside the electronic device 300 regardless of whether the electronic device 300 is in the second state or the first state. For example, the first area 330a may mean a partial area of the display 330 that is not rolled into the internal space of the electronic device 300. According to an embodiment, when the second housing 320 moves, the first area 330a may move together with the second housing 320. For example, when the second housing 320 moves along the first direction or the second direction, the first area 330a may move along the first direction or the second direction on a front surface of the electronic device 300 together with the second housing 320.

According to an embodiment, the second area 330b of the display 330 may be connected to the first area 330a and may be inserted into the internal space of the electronic device 300 or may be extracted from the internal space of the electronic device 300 to the outside, according to the movement of the second housing 320. For example, the second area 330b of the display 330 may be in a state of being inserted into the internal space of the electronic device 300 in a rolled state, in the first state of the electronic device 300. The second area 330b of the display 330 may be inserted into the internal space of the electronic device 300 in the first state of the electronic device 300 and may not be visible from the outside. For another example, the second area 330b of the display 330 may be a state of being extracted from the internal space of the electronic device 300 in the second state of the electronic device 300. The second area 330b of the display 330 may be visible from the outside of the electronic device 300 in the second state.

According to an embodiment, in the first state of the electronic device 300, the area of the display 330 visible from the outside of the electronic device 300 may include only the first area 330a of the display 330. The area of the display 330 visible from the outside of the electronic device 300 in the second state of the electronic device 300 may include at least a portion of the first area 330a and the second area 330b of the display 330.

According to an embodiment, the first housing 310 of the electronic device 300 may include a book cover 311 surrounding the internal space of the first housing 310 and a rear plate 312 surrounding a rear surface of the book cover 311. The second housing 320 of the electronic device 300 may include a front cover 321 surrounding the internal space of the electronic device 300.

According to an embodiment, the front cover 321 may include a first cover area 321a of the front cover 321 that is not inserted into the first housing 310 and a second cover area 321b that is inserted into or extracted from inside of the first housing 310. The first cover area 321a of the front cover 321 may always be visible regardless of whether the electronic device 300 is in the second state and the first state. According to an embodiment, at least a portion of the first cover area 321a of the front cover 321 may form the lateral surface 320a of the second housing 320. According to an embodiment, the second cover area 321b of the second housing 320 may not be visible in the first state, but may be visible in the second state.

The camera 340 may obtain an image of a subject based on receiving light from the outside of the electronic device 300. According to an embodiment, the camera 340 may include one or a plurality of lenses, an image sensor, and/or an image signal processor. According to an embodiment, the camera 340 may be disposed in the second housing 320 to face the rear surface of the electronic device 300 opposite to the front surface of the electronic device 300 in which the first area 330a of the display 330 is disposed. For example, the camera 340 may be disposed on the front cover 321 of the second housing 320 and may be visible from the outside of the electronic device 300 through an opening 311a formed in the book cover 311 when the electronic device 300 is in the first state. For another example, the camera 340 may be disposed on the front cover 321 of the second housing 320 and may not be visible from the outside of the electronic device 300 by being covered by the book cover 311 and/or the rear plate 312 when the electronic device 300 is in the first state.

According to an embodiment, the camera 340 may include a plurality of cameras. For example, the camera 340 may include a wide-angle camera, an ultra-wide-angle camera, a telephoto camera, a proximity camera, and/or a depth camera. However, the camera 340 is not necessarily limited to including a plurality of cameras, and may include one camera.

According to an embodiment, the camera 340 may further include a camera (not illustrated) aimed at the front surface of the electronic device 300 in which the first area 330a of the display 330 is disposed. In case that the camera 340 faces the front surface of the electronic device 300, the camera 340 may be an under display camera (UDC) disposed (e.g., in a +z direction from the display 330) under the display 330, but is not limited thereto.

According to an embodiment, the electronic device 300 may include a sensor module (not illustrated) and/or a camera module (not illustrated) disposed under the display 330. The sensor module may detect the external environment based on information (e.g., light) received through the display 330. According to an embodiment, the sensor module may include at least one of a receiver, a proximity sensor, an ultrasonic sensor, a gesture sensor, a gyro sensor, atmospheric pressure sensor, a magnetic sensor, an acceleration sensor, a grip sensor, a color sensor, an infrared (IR) sensor, a biometric sensor, a temperature sensor, a humidity sensor, a motor encoder, or an indicator. According to an embodiment, at least some sensor modules of the electronic device 300 may be visually exposed from the outside through a partial area of the display 330. According to an embodiment, the electronic device 300 may detect the extraction length (e.g., length A) by using the sensor module. According to an embodiment, the electronic device 300 may generate extracting information on a degree of extracting detected by the sensor. For example, the electronic device 300 may detect and/or check the degree of extracting of the second housing 320 by using the extracting information. According to an embodiment, the extracting information may include information on the extraction length of the second housing 320.

According to an embodiment, a coupling form of the first housing 310 and the second housing 320 is not limited to the shape and coupling illustrated in FIGS. 3A, 3B, 3C, and 3D, and may be implemented by a combination and/or coupling of another shape or component.

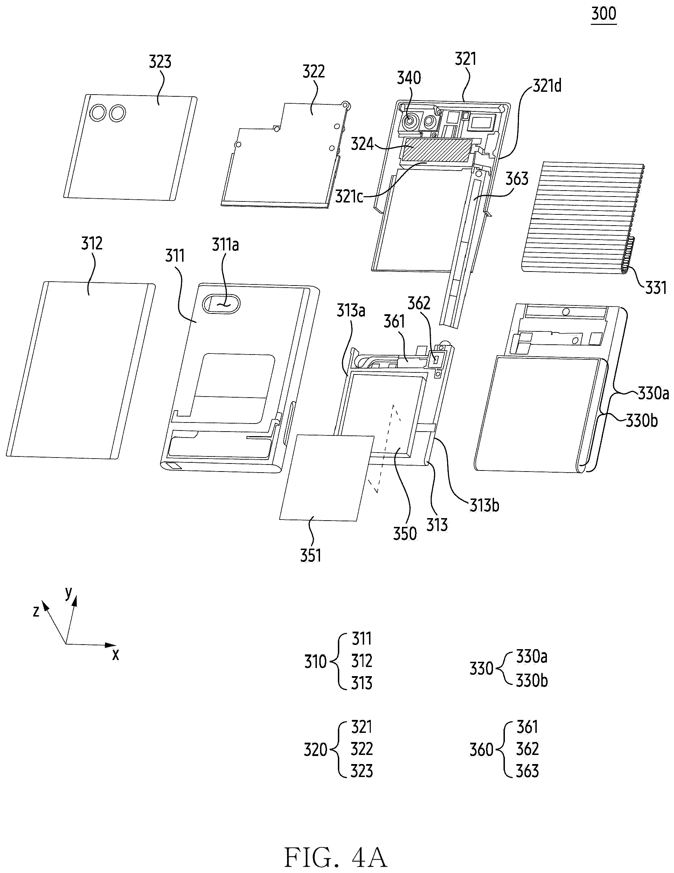

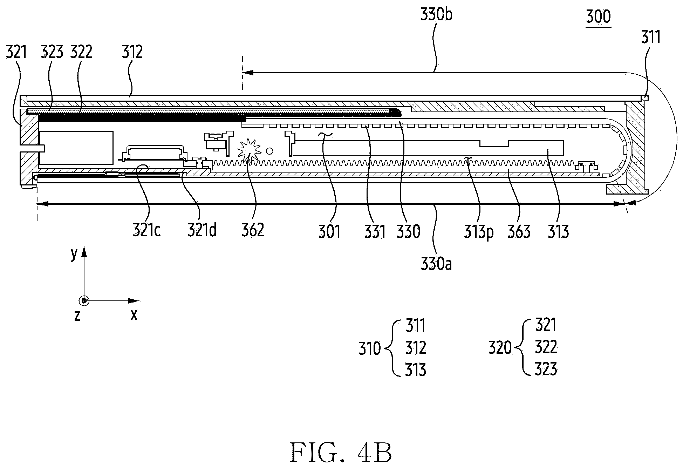

FIG. 4A is an exploded perspective view of an electronic device according to an embodiment, and FIG. 4B is a cross-sectional view illustrating an example of an electronic device cut along A-A' of FIG. 3A according to an embodiment.

Referring to FIGS. 4A and 4B, an electronic device 300 according to an embodiment may include a first housing 310, a second housing 320, a display 330, a camera 340, a battery 350 (e.g., a battery 189 of FIG. 1) and a driving unit 360. According to an embodiment, the first housing 310 and the second housing 320 may form an internal space 301 of the electronic device 300 by being coupled to each other. For example, in a first state of the electronic device 300, a second area 330b of the display 330 may be accommodated in the internal space 301.

According to an embodiment, the first housing 310 may include a book cover 311, a rear plate 312, and a frame cover 313. According to an embodiment, the book cover 311, the rear plate 312, and the frame cover 313 included in the first housing 310 are combined with each other and may not move when the second housing 320 moves with respect to the first housing 310. According to an embodiment, the book cover 311 may form at least a portion of an outer surface of the electronic device 300. For example, the book cover 311 may form at least a portion of a lateral surface of the electronic device 300 and may form at least a portion of a rear surface of the electronic device 300. According to an embodiment, the rear plate 312 may provide a surface on which the rear plate 312 is seated. The rear plate 312 may be seated on one surface of the book cover 311.

According to an embodiment, the frame cover 313 may support internal components of the electronic device 300. For example, the frame cover 313 may accommodate at least a portion of the battery 350 and the driving unit 360. The battery 350 and the driving unit 360 may be accommodated in at least one of a recess or a hole included in the frame cover 313. According to an embodiment, the frame cover 313 may be surrounded by the book cover 311. For example, in the first state of the electronic device 300, one surface 313a of the frame cover 313 on which the battery 350 is disposed may be opposite to the book cover 311 and/or the second area 330b of the display 330. For another example, in the first state of the electronic device 300, another surface 313b of the frame cover 313 opposing the one surface 313a of the frame cover 313 may be opposite to a first area 330a of the display 330 or a front cover 321. For example, the frame cover 313 may include aluminum as a material, but is not limited thereto.

According to an embodiment, the second housing 320 may include the front cover 321, a rear cover 322, and a slide cover 323. According to an embodiment, the front cover 321, the rear cover 322, and the slide cover 323 may be coupled with each other and may move together with the second housing 320 when the second housing 320 relatively moves with respect to the first housing 310. The front cover 321 may support the internal components of the electronic device 300. For example, a printed circuit board 324 and/or the camera 340 on which the electronic components (e.g., a processor 120 of FIG. 1) of the electronic device 300 are disposed may be disposed on one surface 321c of the front cover 321 facing the internal space 301. Another surface 321d of the front cover 321 opposing one surface 321a of the front cover 321 may be opposite to the first area 330a of the display 330 when the electronic device 300 is in the first state. According to an embodiment, the rear cover 322 may protect components of the electronic device 300 disposed on the front cover 321, by being coupled to the front cover 321. For example, the rear cover 322 may cover a portion of the one surface 321c of the front cover 321. According to an embodiment, the slide cover 323 may form the outer surface of the electronic device 300 together with the rear plate 312 and the book cover 311, by being disposed on the rear cover 322. The slide cover 323 may protect the rear cover 322 and/or the front cover 321, by being coupled to one surface of the rear cover 322.

According to an embodiment, when the electronic device 300 is in the first state, the display 330 may be bent by being rolled into the internal space 301 at least in part. According to an embodiment, the display 330 may cover at least a portion of the frame cover 313 and at least a portion of the front cover 321. For example, when the electronic device 300 is in the first state, the display 330 may cover the other surface 321d of the front cover 321, pass between the front cover 321 and the book cover 311, and extend toward the internal space 301. The display 330 may surround the frame cover 313 after passing between the front cover 321 and the book cover 311. The display 330 may cover the one surface 313a of the frame cover 313 in the internal space 301. According to an embodiment, when the second housing 320 moves in the first direction, the second area 330b of the display 330 may be extracted from the internal space 301. For example, as the second housing 320 moves in the second direction, the display 330 may pass between the front cover 321 and the book cover 311 and may be extracted from the internal space 301.

According to an embodiment, the electronic device 300 may include a support bar 331 supporting the display 330. For example, the support bar 331 may include a plurality of bars coupled to each other and may be manufactured in a shape corresponding to a shape of the second area 330b of the display 330. According to an embodiment, as the display 330 moves, the support bar 331 may move together with the display 330. For example, as the display 330 moves, the support bar 331 may move along a guide rail (not illustrated) coupled to the frame cover 313. According to an embodiment, in the first state in which the second area 330b of the display 330 is rolled in the internal space 301, the support bar 331 may be rolled in the internal space 301 together with the second area 330b of the display 330. As the second housing 320 moves in the first direction, the support bar 331 may move together with the second area 330b of the display 330.

According to an embodiment, the electronic device 300 may further include a battery plate 351. The battery plate 351 may prevent the battery 350 from being damaged by movement of the display 330 or the support bar 331. According to an embodiment, the battery plate 351 may cover at least a portion of one surface of the battery 350 facing the second area 330b of the display 330. According to an embodiment, the battery plate 351 may be coupled to the frame cover 313. For example, the battery plate 351 may be coupled to the frame cover 313 through a coupling member (e.g., screw), but is not limited thereto.

According to an embodiment, the driving unit 360 may provide a driving force to the second housing 320 so that the second housing 320 may relatively move with respect to the first housing 310. According to an embodiment, the driving unit 360 may include a motor 361, a pinion gear 362, and a rack gear 363. The motor 361 may receive power from the battery 350 to provide driving force to the second housing 320. According to an embodiment, the motor 361 may be disposed in the first housing 310 and may not move when the second housing 320 moves with respect to the first housing 310. For example, the motor 361 may be disposed in a recess formed in the frame cover 313. According to an embodiment, the pinion gear 362 may be coupled to the motor 361 and may rotate by the driving force provided from the motor 361. According to an embodiment, the rack gear 363 may engage with the pinion gear 362 and may move according to rotation of the pinion gear 362. For example, the rack gear 363 may linearly reciprocate in the first direction or the second direction according to the rotation of the pinion gear 362. According to an embodiment, the rack gear 363 may be disposed in the second housing 320. For example, the rack gear 363 may be coupled to the front cover 321 included in the second housing 320. According to an embodiment, the rack gear 363 may be movable inside an operating space 313p formed in the frame cover 313.

According to an embodiment, when the pinion gear 362 rotates along a first rotation direction (e.g., clockwise in FIG. 4B), the rack gear 363 may move in the first direction (e.g., +y direction). When the rack gear 363 moves along the first direction, the second housing 320 coupled to the rack gear 363 may move along the first direction. As the second housing 320 moves along the first direction, the area of the display 330 visible from the outside of the electronic device 300 may be expanded. When the pinion gear 362 rotates along a second rotation direction (e.g., counterclockwise in FIG. 4B), the rack gear 363 may move in the second direction (e.g., -y direction). When the rack gear 363 moves along the second direction, the second housing 320 coupled to the rack gear 363 may move along the second direction. As the second housing 320 moves along the second direction, the area of the display 330 visible from the outside of the electronic device 300 may be reduced.

In the above description, although it has been described that the motor 361 and the pinion gear 362 are disposed in the first housing 310, and the rack gear 363 is disposed in the second housing 320, embodiments may not be limited thereto. According to embodiments, the motor 361 and the pinion gear 362 may be disposed in the second housing 320, and the rack gear 363 may be disposed in the first housing 310.

In order to be transmitted from the battery 350 to the electronic components (e.g., the processor 120, the camera 340, the display 330, or the motor 361) in the electronic device 300, power needs to go through power management circuitry before being transmitted from the battery 350 to the electronic components. In case that a power management module (e.g., a power management module 188 of FIG. 1) that manages power supplied to the electronic components in the electronic device 300 is disposed only on the printed circuit board 324 in the second housing 320, power loss may occur. For example, since the power supplied to the motor 361 must be transmitted from the battery 350 in the first housing 310 to the second housing 320 and then transmitted back to the motor 361 in the first housing 310, the loss may occur in the process of transmitting the power. The loss occurring in the process of transmitting the power may increase as the distance between the battery 350 and the printed circuit board 324 increases as the electronic device 300 switches from the first state to the second state. When the power loss occurs, the power of the battery 350 of the electronic device 300 is wasted, and thus the electronic device 300 may not be able to provide various functions to the user. Hereinafter, in order to minimize the power loss, the electronic device 300 capable of providing a structure to minimize a distance between the battery 350 and the power management circuitry will be described. Hereinafter, since the same reference numeral as the reference numeral of the above-described component may refer to the substantially same component as the above-described component, an overlapping description will be omitted.

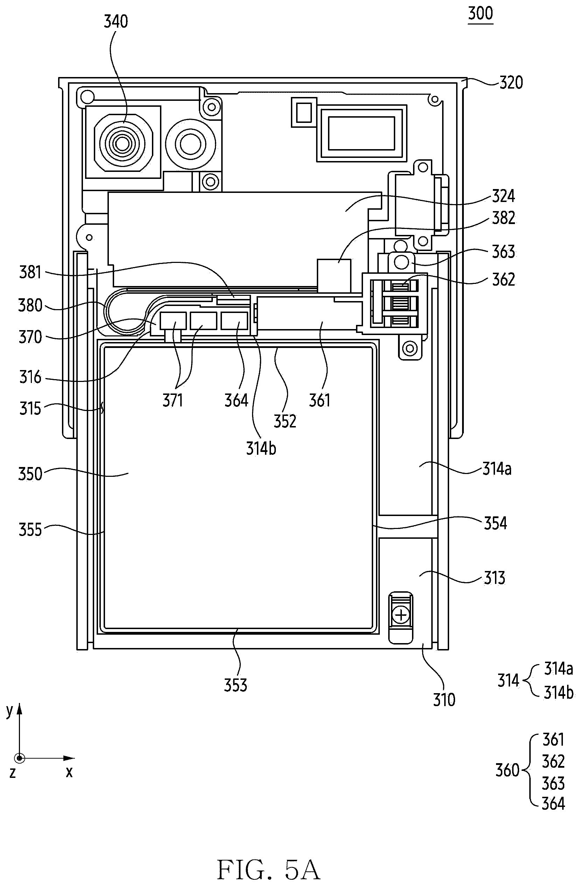

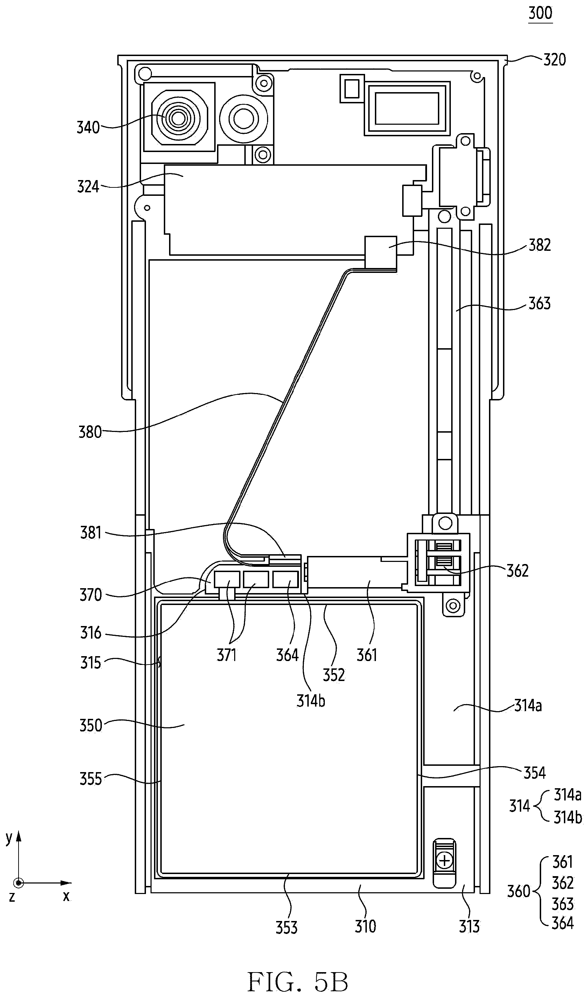

FIG. 5A is a rear view of a first state of an electronic device in a state in which a book cover is removed, according to an embodiment, and FIG. 5B is a rear view of a second state of an electronic device in a state in which a book cover is removed, according to an embodiment.

Referring to FIGS. 5A and 5B, according to an embodiment, an electronic device 300 may further include a first printed circuit board 324, a second printed circuit board 370, and a flexible printed circuit board 380. According to an embodiment, since the first printed circuit board 324 may be substantially the same as the printed circuit board 324 of FIGS. 4A and 4B, an overlapping description will be omitted.

According to an embodiment, a first housing 310 may accommodate some of components of the electronic device 300. According to an embodiment, the first housing 310 may include partition walls 314 of a frame cover 313 compartmentalizing spaces for accommodating some of the components of the electronic device 300. For example, the partition walls 314 of the frame cover 313 may form a first recess 315 for accommodating a battery 350. When the battery 350 is accommodated in the first recess 315, the partition walls 314 of the frame cover 313 may surround the battery 350. For another example, a first partition wall 314a among the partition walls 314 of the frame cover 313 may provide an operating space (e.g., an operating space 313p of FIG. 4B) in which the rack gear 363 is movable therein.

According to an embodiment, the battery 350 may be accommodated in the first recess 315 of the frame cover 313 in the first housing 310. According to an embodiment, when the second housing 320 moves, the battery 350 is accommodated in the first recess 315, so that the battery 350 may not move within the first housing 310. According to an embodiment, the battery 350 may include a plurality of lateral surfaces 352, 353, 354, and 355. For example, the battery 350 may include a first lateral surface 352 facing the first printed circuit board 324 in a first direction (e.g., +y direction), a second lateral surface 353 opposing the first lateral surface 352 and facing a second direction (e.g., -y direction) opposite the first direction, a third lateral surface 354 perpendicular to the first lateral surface 352 and the second lateral surface 353 and opposing the rack gear 363, and a fourth lateral surface 355 perpendicular to the first lateral surface 352 and the second lateral surface 353 and opposing the third lateral surface 354.

According to an embodiment, a motor 361 may be disposed in the first housing 310. According to an embodiment, the motor 361 may be disposed between the battery 350 and the first printed circuit board 324. For example, the motor 361 may be disposed closer to the first lateral surface 352 among the first lateral surface 352 and the second lateral surface 353 of the battery 350.

According to an embodiment, the second printed circuit board 370 (PCB) may form an electrical connection between electronic components in the first housing 310. For example, the second printed circuit board 370 may be electrically connected to the battery 350 and the motor 361. According to an embodiment, the second printed circuit board 370 may be disposed in the first housing 310. For example, the second printed circuit board 370 may be spaced apart from the battery 350 and disposed in the frame cover 313. The second printed circuit board 370 may be accommodated in a second recess 316 of the first housing 310. The second recess 316 may be distinguished from the first recess 315 by a plurality of partition walls 314 and may be spaced apart from the first recess 315. For example, among the plurality of partition walls 314, a second partition wall 314b, which is distinguished from the first partition wall 314a accommodating the rack gear 363, may be disposed between the second printed circuit board 370 and the first lateral surface 352 of the battery 350. For another example, the second printed circuit board 370 may be disposed on one surface of the battery 350. According to an embodiment, the second printed circuit board 370 may be coupled to the frame cover 313 through a coupling member (e.g., screw). By being coupled to the frame cover 313, the second printed circuit board 370 may not move according to the movement of the second housing 320.

According to an embodiment, the second printed circuit board 370 may be disposed between the battery 350 and the first printed circuit board 324. For example, the second printed circuit board 370 may be disposed closer to the first lateral surface 352 among the first lateral surface 352 and the second lateral surface 353 of the battery 350. According to an embodiment, the second printed circuit board 370 may be opposite to one end of the motor 361. The one end of the motor 361 may mean a portion of the motor 361 opposing another end of the motor 361 coupled to a pinion gear 362.

According to an embodiment, the second printed circuit board 370 may include a plurality of electronic components 371. At least some of the plurality of electronic components 371 may form a first power management circuitry. For example, the first power management circuitry may include at least some of the plurality of electronic components 371 disposed on one surface of the second printed circuit board 370. The first power management circuitry may transmit power of the battery 350 to the first printed circuit board 324 through the flexible printed circuit board 380. The first printed circuit board 324 may receive power through the flexible printed circuit board 380 and may transmit the received power to another electronic component (e.g., the motor 361) in the electronic device 300. However, it is not limited thereto. For example, the power transmitted from the battery 350 to the first power management circuitry disposed on the second printed circuit board 370 may be directly transmitted to motor driving circuitry 364 without passing through the flexible printed circuit board 380 and the first printed circuit board 324. According to an embodiment, the plurality of electronic components 371 may include at least one of charging circuitry (e.g., charging circuitry 210 of FIG. 2), power adjustment circuitry (e.g., a power adjuster 220 of FIG. 2), a power gauge (e.g., a power gauge 230 of FIG. 2), and switching circuitry. The charging circuitry may charge the battery 350 using power supplied from the outside of the electronic device 300. For example, the charging circuitry may include at least one of wired charging circuitry for wired charging and wireless charging circuitry for wireless charging. The switching circuitry may be configured to switch a current path extending to the battery 350 for charging or discharging the battery 350. For example, the switching circuitry may include a power supply switch (e.g., FET, QBAT).

According to an embodiment, the plurality of electronic components 371 may form integrated circuitry in an area of the second printed circuit board 370. In case that the plurality of electronic components 371 form the integrated circuit, the first power management circuitry may be referred to as power management integrated circuitry (PMIC). According to another embodiment, the plurality of electronic components 371 may be spaced apart from each other on the one surface of the second printed circuit board 370. The plurality of electronic components 371 spaced apart from each other on the one surface of the second printed circuit board 370 may form first power management circuitry, by being electrically connected to each other in a spaced apart state.

According to an embodiment, the second printed circuit board 370 may include the motor driving circuitry 364 operably coupled to the motor 361 and the first power management circuitry. For example, the motor driving circuitry 364 may be configured to control power for driving the motor 361 based on receiving power from the first power management circuitry. For example, the motor driving circuitry 364 may be configured to control the motor 361 based on a control signal received from at least one processor (e.g., a processor 120 of FIG. 1) of the first printed circuit board 324. For example, the motor driving circuitry 364 may receive power via the flexible printed circuit board 380 and the first printed circuit board 324 from the first power management circuitry. The motor driving circuitry 364 may transmit power for driving the motor 361 to the motor 361 based on receiving power from the first printed circuit board 324.

According to an embodiment, the first printed circuit board 324 may include second power management circuitry (not illustrated) distinguished from the first power management circuitry. The second power management circuitry may manage power supplied to a plurality of other electronic components (e.g., a camera 340 or the processor 120 of FIG. 1) disposed on the one surface of the second printed circuit board. For example, the second power management circuitry may be referred to a power management module 188 of FIG. 2. According to an embodiment, the second power management circuitry may manage power supplied to a plurality of other electronic components disposed on the first printed circuit board 324, based on power supplied from the first power management circuitry disposed on the second printed circuit board 370. However, it is not limited thereto, and the first printed circuit board 324 may not include the second power management circuitry. In case that the first printed circuit board 324 does not include the second power management circuitry, power supplied to a plurality of other electronic components disposed on the first printed circuit board 324 may be managed by the first power management circuitry of the second printed circuit board 370.

The flexible printed circuit board 380 may electrically connect the second printed circuit board 370 and the first printed circuit board 324. For example, the flexible printed circuit board 380 may connect the second printed circuit board 370 and the first printed circuit board 324 by being connected to a first connector 381 disposed on the second printed circuit board 370 and a second connector 382 disposed on the first printed circuit board 324. According to an embodiment, the flexible printed circuit board 380 may be a flexible printed circuit board (FPCB) manufactured as a component separate from the second printed circuit board 370 and the first printed circuit board 324, but is not limited thereto. For example, the flexible printed circuit board 380 may form a rigid flexible printed circuit board (RFPCB) together with at least one of the second printed circuit board 370 or the first printed circuit board 324, by being manufactured integrally with the second printed circuit board 370 or the first printed circuit board 324.

According to an embodiment, the flexible printed circuit board 380 may be folded when the electronic device 300 is in the first state and unfolded when the electronic device 300 is in the second state. The flexible printed circuit board 380 may be unfolded or folded according to the movement of the second housing 320. For example, in case that the second housing 320 moves in the first direction (e.g., -y direction), the first printed circuit board 324 may move in the first direction together with the second housing 320. As the first printed circuit board 324 moves in the first direction, the flexible printed circuit board 380 connected to the first printed circuit board 324 may be unfolded. For another example, in case that the second housing 320 moves in a second direction (+y direction) opposite to the first direction, the first printed circuit board 324 may move in the second direction together with the second housing 320. As the first printed circuit board 324 moves in the second direction, the flexible printed circuit board connected to the first printed circuit board 324 may be folded.

As described above, according to an embodiment, the second printed circuit board 370 including the first power management circuitry is disposed in the first housing 310, so that the electronic device 300 may prevent power loss of the battery 350. For example, in case that the first power management circuitry is not disposed on the second printed circuit board 370, power of the battery 350 may have to pass through the first printed circuit board 324 in order to supply power to electronic components (e.g., the motors 361) in the first housing 310. After the power of the battery 350 passes through the first printed circuit board 324, the power loss may occur in the process of being supplied to the electronic component in the first housing 310 again. The power loss may increase as a distance between the battery 350 and the first printed circuit board 324 increases. In case that the electronic component is not mounted in the first housing 310, the power loss may be prevented, but a mounting space in the electronic device 300 may be wasted. In case that the mounting space is wasted, the electronic device 300 may not be able to mount various electronic components, and thus may not provide various functions to user. As the second printed circuit board 370 including the first power management circuitry is disposed in the first housing 310, the electronic device 300 according to an embodiment may provide a structure capable of preventing the power loss that may occur when the power of the battery 350 is supplied to the electronic components in the first housing 310. According to an embodiment, since the second printed circuit board 370 including the first power management circuitry is disposed in the first housing 310, so that electronic components capable of providing various functions may be mounted in the first housing 310, the electronic device 300 may provide various functions to the user.

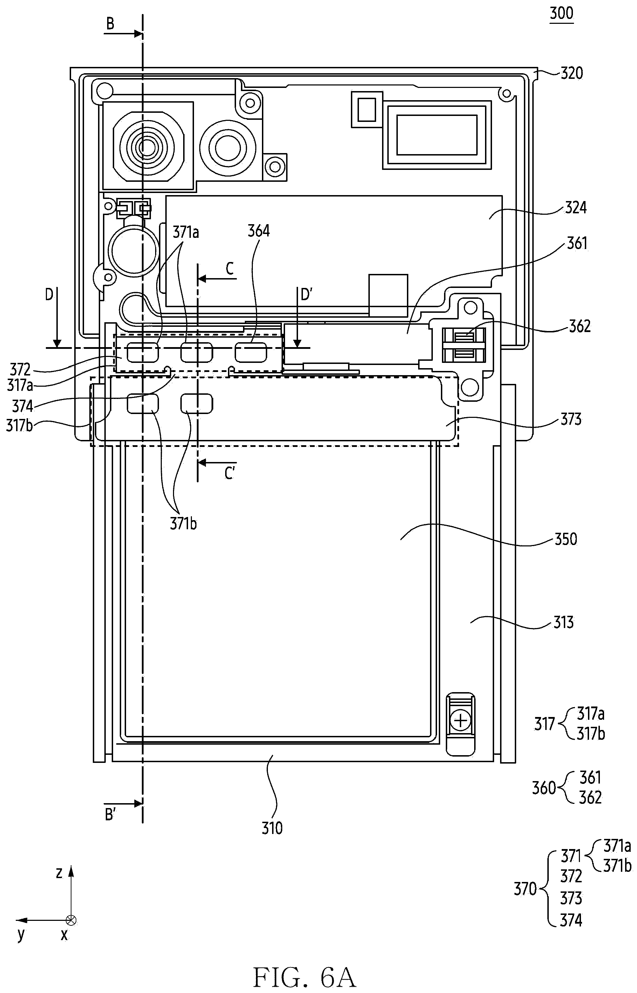

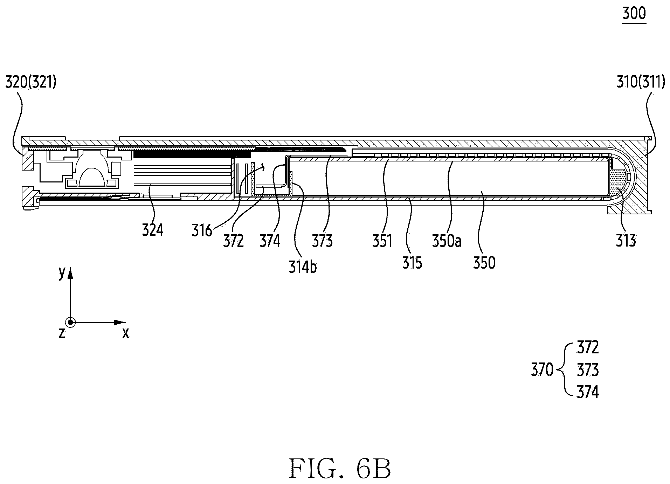

FIG. 6A is a rear view of a first state of an electronic device in a state in which a book cover is removed, according to an embodiment, and FIG. 6B is a cross-sectional view illustrating an example in which an electronic device is cut along B-B' of FIG. 6A in a state in which a bracket is removed, according to an embodiment.

Since an electronic device 300 of FIGS. 6A and 6B may be an electronic device 300 in which a second printed circuit board 370 and a first housing 310 are changed in the electronic device 300 of FIGS. 5A and 5B, an overlapping description will be omitted.

Referring to FIGS. 6A and 6B, according to an embodiment, the second printed circuit board 370 of the electronic device 300 may include a first substrate 372, a second substrate 373, and a connecting portion 374. According to an embodiment, the second printed circuit board 370 including the first substrate 372, the second substrate 373, and the connecting portion 374 may be a rigid flexible printed circuit board (RFPCB), but is not limited thereto. For example, the first substrate 372 and the second substrate 373 may form different printed circuit boards and may be electrically connected to each other through the connecting portion 374, which is a flexible printed circuit board.

The first substrate 372 may be an area of the second printed circuit board 370 having rigidity compared to the connecting portion 374. According to an embodiment, the first substrate 372 may be accommodated in a second recess 316 in the first housing 310. For example, the first substrate 372 may be spaced apart from the first recess 315 in which the battery 350 is disposed. As the first substrate 372 is accommodated in the second recess 316, a second partition wall 314b among a plurality of partition walls 314 may be disposed between the first substrate 372 and a first lateral surface 352 of the battery 350.

The second substrate 373 may be another area of the second printed circuit board 370 having rigidity compared to the connecting portion 374. According to an embodiment, the second substrate 373 may be disposed on one surface 350a of the battery 350. When the electronic device 300 is in the first state, the one surface 350a of the battery 350 may be opposite to at least a portion of a second area (e.g., a second area 330b of FIGS. 4A and 4B) of a display (e.g., a display 330 of FIGS. 4A and 4B). For example, the second substrate 373 may be disposed on a battery plate 351. As the second substrate 373 is disposed on the battery plate 351, the battery plate 351 may be interposed between at least a portion of the second substrate 373 and the battery 350.

According to an embodiment, the second substrate 373 may form a step with respect to the first substrate 372. For example, a height (e.g., a distance to a +z axis) from one surface 313a of the frame cover 313 on which the battery 350 is disposed to the second substrate 373 may be greater than a height from the one surface 313a of the frame cover 313 to the first substrate 372.

According to an embodiment, the first substrate 372 and the second substrate 373 may be coupled to the frame cover 313 through a coupling member (e.g., screw).

The connecting portion 374 may connect the first substrate 372 and the second substrate 373. According to an embodiment, the connecting portion 374 may be another area of the second printed circuit board 370 having flexibility compared to the first substrate 372 and the second substrate 373. For example, the connecting portion 374 may extend from the first substrate 372 to the second substrate 373 along an outer surface of the second partition wall 341b and an outer surface of the battery plate 351. According to an embodiment, the connecting portion 374 may be electrically connected to the first substrate 372 and the second substrate 373 through a connector (not illustrated), but is not limited thereto. For example, the connecting portion 374 may be electrically connected to the first substrate 372 and the second substrate 373, by being formed integrally with the first substrate 372 and the second substrate 373. According to an embodiment, the connecting portion 374 may be referred to as a flexible printed circuit board or cable for electrically connecting the first substrate 372 and the second substrate 373.

According to an embodiment, the second printed circuit board 370 may include a plurality of electronic components 371 forming first power management circuitry. At least some of the plurality of electronic components 371 may form the first power management circuitry, by being electrically connected to each other in a state of being spaced apart from each other on the second printed circuit board 370. According to an embodiment, a portion 371a of the plurality of electronic components 371 may be disposed on the first substrate 372, and another portion 371b of the plurality of electronic components 371 may be disposed on the second substrate 373. For example, in case that the second printed circuit board 370 is not disposed on the battery 350, the second printed circuit board 370 may not include various types of the plurality of electronic components 371. According to an embodiment, the electronic device 300 may provide a structure in which various types of the plurality of electronic components 371 may be mounted, by including the second substrate 373 disposed on the battery 350.

According to an embodiment, a heat emission rate of the other portion 371b of the plurality of electronic components 371 disposed on the second substrate 373 may be lower than a heat emission rate of the portion 371a of the plurality of electronic components 371. The heat emission rate may mean the amount of heat emitted from each of the plurality of electronic components 371 as the electronic device 300 operates for a unit time. For example, the portion 371a of the plurality of electronic components 371 may include at least one of wired charging circuitry and wireless charging circuitry. For another example, the portion 371a of the plurality of electronic components 371 may include motor driving circuitry 364. For another example, the other portion 371b of the plurality of electronic components 371 may include switching circuitry.

In case that an electronic component having a high heat emission rate is disposed on the second substrate 373 adjacent to the battery 350, operation performance of the electronic device 300 may be deteriorated. In order to prevent the operation performance of the electronic device 300 from deteriorating, in case that the electronic component is not disposed on the second substrate 373, a mounting space in the electronic device 300 may be wasted and various functions may not be provided to the user. According to an embodiment, the electronic device 300 may provide a structure that prevents the operation performance of the electronic device 300 from deteriorating and saves the mounting space of the electronic device 300, by disposing an electronic component having a relatively high heat emission rate on the first substrate 372 and by disposing an electronic component having a relatively low heat emission rate on the second substrate 373.

According to an embodiment, the first housing 310 may include a bracket 317 that supports the second printed circuit board 370 in the first housing 310. The bracket 317 may cover at least a portion of the second printed circuit board 370. According to an embodiment, the bracket 317 may be coupled to the frame cover 313 and may be in contact with the second printed circuit board 370. For example, the bracket 317 may be coupled to the frame cover 313 through the coupling member (e.g., screw). According to an embodiment, the bracket 317 may include a stainless steel as a material, but is not limited thereto.

According to an embodiment, the bracket 317 may include a first bracket 317a covering the first substrate 372 and a second bracket 317b covering the second substrate 373. The first bracket 317a may be coupled to the frame cover 313 to cover the second recess 316. The second bracket 317b may cover the second substrate 373 and may be coupled to the frame cover 313.

As described above, according to an embodiment, since the plurality of electronic components 371 included in the second printed circuit board 370 are disposed on the first substrate 372 and the second substrate 373, respectively, the electronic device 300 may provide a structure that saves the mounting space in the electronic device 300. The electronic device 300 according to an embodiment may provide a structure that prevents heat from being transmitted to the battery 350, because the electronic component having the low heat emission rate among the plurality of electronic components 371 is disposed on the second substrate 373 and the electronic component having the high heat emission rate is disposed on the first substrate 372.

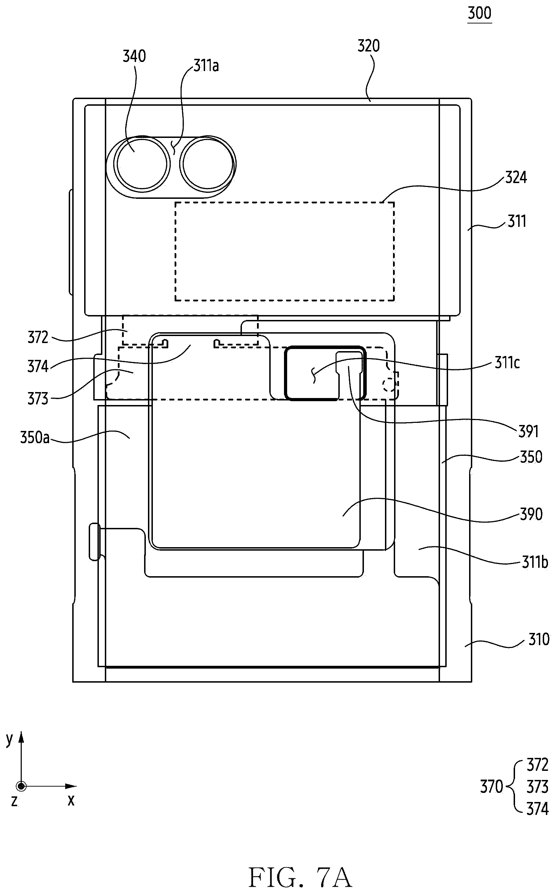

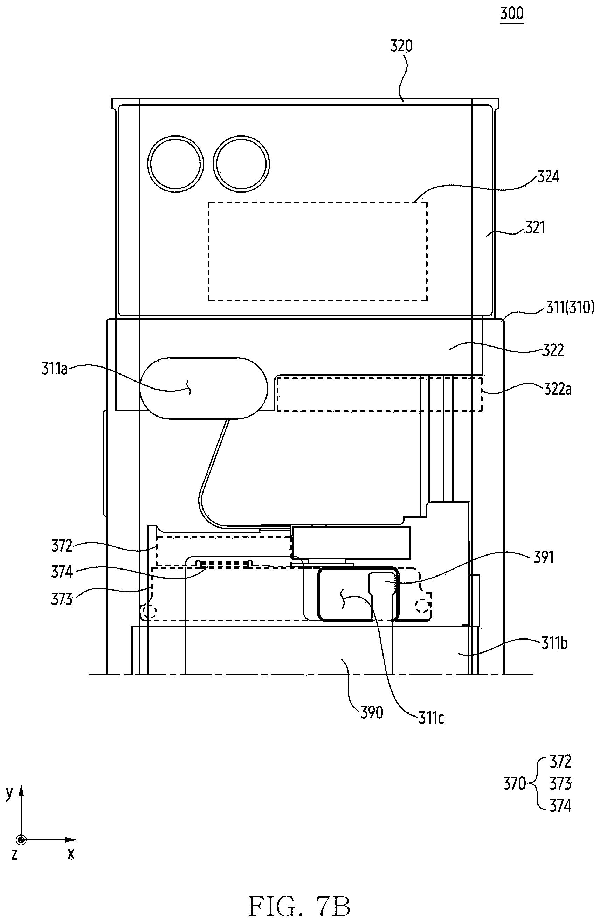

FIG. 7A is a rear view of a first state of an electronic device according to an embodiment, and FIG. 7B is a rear view of a second state of an electronic device according to an embodiment.

Since an electronic device 300 of FIGS. 7A and 7B may be the electronic device 300 to which a wireless charging antenna 390 is added in the electronic device 300 of FIGS. 6A and 6B, overlapping description will be omitted.

Referring to FIGS. 7A and 7B, according to an embodiment, first power management circuitry of a second printed circuit board 370 may include first charging circuitry for wireless charging. For example, the first charging circuitry may be disposed on a first substrate 372.

According to an embodiment, the electronic device 300 may further include the wireless charging antenna 390. The wireless charging antenna 390 may receive power from the outside of the electronic device 300 and may transmit the received power to the first power management circuitry of the second printed circuit board 370. For example, based on receiving AC power from the outside of the electronic device 300, the wireless charging antenna 390 may transmit the received AC power to the first power management circuitry. Based on receiving AC power from the wireless charging antenna 390, the first charging circuitry of the first power management circuitry may convert the received AC power into DC power. The charging circuitry of the first power management circuitry may store the converted DC power in a battery 350. For example, the wireless charging antenna 390 may include an MFC antenna, but is not limited thereto.

According to an embodiment, the wireless charging antenna 390 may be disposed on one surface 350a of the battery 350. For example, the wireless charging antenna 390 may be disposed in a book cover 311 included in a first housing 310. According to an embodiment, the wireless charging antenna 390 may be disposed in the first housing 310 in order to be at least partially overlapped with the battery 350 when the electronic device 300 is viewed from above (e.g., -z direction). For example, at least a portion of the wireless charging antenna 390 may be disposed in an area of the book cover 311 corresponding to the second printed circuit board 370 or the battery 350. According to an embodiment, one surface 311b of the book cover 311 in which the wireless charging antenna 390 is disposed may be directed in a direction parallel to a direction (e.g., +z direction) toward a rear surface of the electronic device 300. As the wireless charging antenna 390 is disposed adjacent to the battery 350, power received from the wireless charging antenna 390 may be efficiently transmitted to the battery 350.

According to an embodiment, the wireless charging antenna 390 may be electrically connected to the second printed circuit board 370 through a connector 391. For example, as the connector 391 is coupled to the second substrate 373 disposed on the one surface 350a of the battery 350, the wireless charging antenna 390 may be electrically connected to the second printed circuit board 370.

According to an embodiment, the wireless charging antenna 390 may be disposed closer to the second printed circuit board 370 among the second printed circuit board 370 and the first printed circuit board 324. For example, in case that the electronic device 300 does not include the second printed circuit board 370, the power received from the wireless charging antenna 390 may have to be transmitted back to the battery 350 through the second power management circuitry of the first printed circuit board 324. In case that the power received from the wireless charging antenna 390 has to go through the first printed circuit board 324, power loss occurs in the process of transmitting power to the battery 350, and thus charging efficiency of the electronic device 300 may be reduced. According to an embodiment, the electronic device 300 may prevent the power loss from occurring during the charging process of the battery 350 because the second printed circuit board 370 including the first power management circuitry is disposed adjacent to the wireless charging antenna 390. According to an embodiment, the electronic device 300 may provide a structure in which charging efficiency of the battery 350 is increased by preventing the power loss from occurring.

According to an embodiment, the first housing 310 may include a through hole 311c for assembling the wireless charging antenna 390 and the second printed circuit board 370. By penetrating the book cover 311, the through hole 311c may connect the inside of the book cover 311 on which the second printed circuit board 370 is disposed and the outside of the book cover 311. For example, the through hole 311c may overlap at least a portion of the second substrate 373 when the electronic device 300 is viewed from above (-z direction). When the wireless charging antenna 390 and the second substrate 373 are connected, the connector 391 of the wireless charging antenna 390 may pass through the through hole 311c and may be connected to the second substrate 373.

According to an embodiment, the second housing 320 may include an opening area 322a corresponding to the through hole 311c. The opening area 322a may be an empty space from which a portion of the rear cover 322 of the second housing 320 is removed. For example, when the electronic device 300 is in the first state, the opening area 322a may overlap the through hole 311c of the book cover 311. As the opening area 322a overlaps the through hole 311c, a space for connecting the connector 391 of the wireless charging antenna 390 to the second substrate 373 may be secured.

As described above, the electronic device 300 according to an embodiment may provide a structure that prevents the power loss occurring during the charging process of the battery 350 by including a wireless charging antenna 390 disposed closer to the battery 350 and/or the second printed circuit board 370. The electronic device 300 according to an embodiment may improve the charging efficiency of the battery 350 by preventing the power loss.

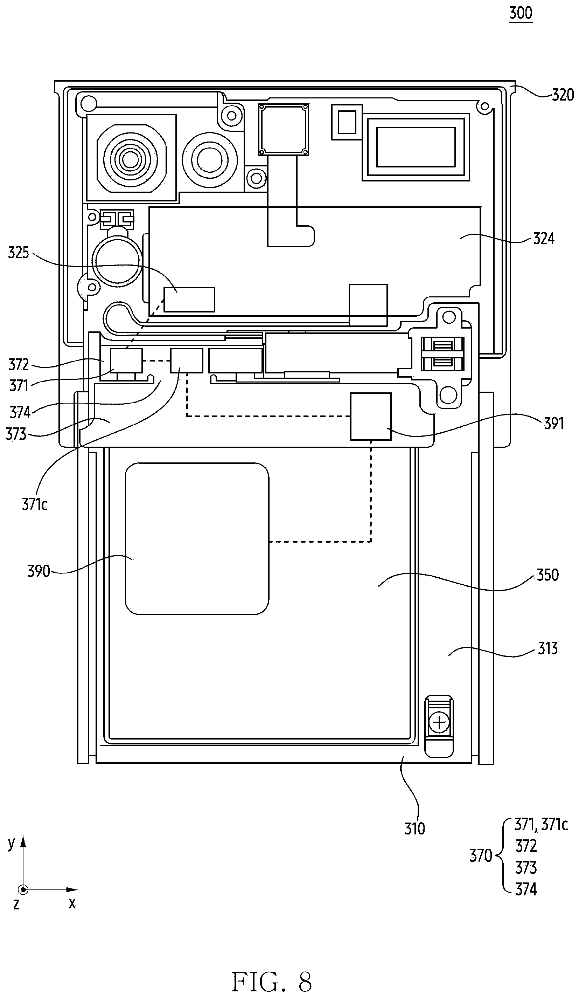

FIG. 8 is a rear view of an electronic device in a state in which a book cover is removed, according to an embodiment.

Referring to FIG. 8, an electrical connection relationship between components in an electronic device 300 of FIGS. 7A and/or 7B may be known in more detail.

According to an embodiment, first power management circuitry of a second printed circuit board 370 may include a plurality of electronic components 371. The plurality of electronic components 371 may include, for example, at least one of a power gauge, switching circuitry (e.g., FET, QBAT), and charging circuitry. According to an embodiment, the plurality of electronic components 371 may include first charging circuitry 371c for receiving power from a wireless charging antenna 390. For example, the first charging circuitry 371c may be disposed on a first substrate 372. According to an embodiment, among the plurality of electronic components 371, an electronic component forming the power gauge and the switching circuitry may be disposed on a second substrate 373, but is not limited thereto. For example, among the plurality of electronic components 371, the electronic component forming the power gauge and the switching circuitry may be disposed on the first substrate 372.

According to an embodiment, the wireless charging antenna 390 may be electrically connected to the second substrate 373 through a connector 391. Power received from the wireless charging antenna 390 may be transmitted to the first charging circuitry 371c of the first substrate 372 through the connector 391 and the second substrate 373. The first charging circuitry 371c may transmit power to the battery 350 based on converting the received power.

According to an embodiment, the first printed circuit board 324 may include a plurality of other electronic components 325. A portion of the plurality of other electronic components 325 may form second power management circuitry. The second power management circuitry may manage power supplied to the plurality of other electronic components of the first printed circuit board 324, based on power received from the first power management circuitry, but is not limited thereto. According to embodiments, the second power management circuitry may be omitted from the electronic device 300.

According to an embodiment, the electronic device 300 may not include wired charging circuitry for wired charging. In case that the electronic device 300 does not include the wired charging circuitry, the battery 350 may be charged only by power received from the wireless charging antenna 390.

As described above, according to an embodiment, the electronic device 300 may provide a structure that prevents the power loss occurring during the charging process of the battery 350 by including the wireless charging antenna 390 disposed closer to the battery 350 and/or the second printed circuit board 370.

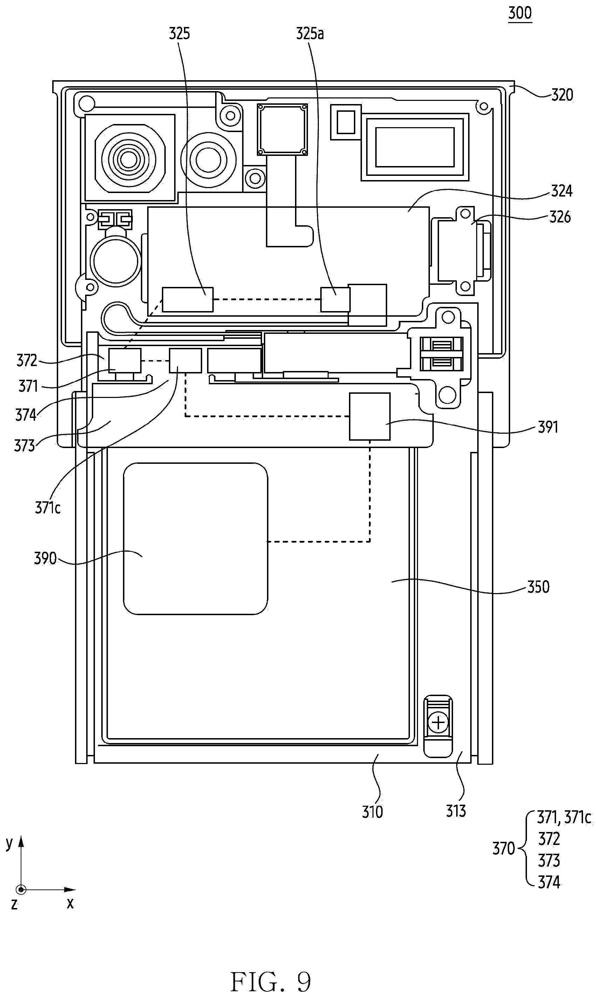

FIG. 9 is a rear view of an electronic device in a state in which a book cover is removed, according to an embodiment.

Since an electronic device 300 of FIG. 9 may be an electronic device 300 in which a connector hole 326 is added from the electronic device 300 of FIG. 8 and an electrical connection relationship of components in the electronic device 300 has been changed, an overlapping description will be omitted.

Referring to FIG. 9, according to an embodiment, a second housing 320 of the electronic device 300 may include the connector hole 326. The connector hole 326 may be configured to receive power supplied from the outside of the electronic device 300. For example, the connector hole 326 may be configured to receive power supplied by wire from the outside of the electronic device 300.

According to an embodiment, a first printed circuit board 324 may include a plurality of other electronic components 325. A portion of the plurality of other electronic components 325 may form second power management circuitry. The second power management circuitry of the first printed circuit board 324 may include second charging circuitry 325a configured to transmit power received from the connector hole 326 to the battery 350. For example, the second charging circuitry 325a may be referred to as wired charging circuitry.

According to an embodiment, first power management circuitry may include the plurality of electronic components 371. The plurality of electronic components 371 may include, for example, at least one of power gauge, switching circuitry, and charging circuitry. According to an embodiment, the plurality of electronic components 371 may include first charging circuitry 371c for receiving power from a wireless charging antenna 390. For example, the first charging circuitry 371c may be disposed on a first substrate 372. According to an embodiment, in case that the second housing 320 includes the connector hole 326, the first power management circuitry may not include a power supply switch (e.g., QBAT).

According to an embodiment, in case that the second housing 320 includes the connector hole 326, the portion of the plurality of other electronic components 325 forming the second power management circuitry of the first printed circuit board 324 may include the power supply switch (e.g., QBAT).

As described above, in the electronic device 300 according to an embodiment, in case that the second housing 320 includes the connector hole 326, the second charging circuitry 325a receiving power from the connector hole 326 may be disposed on the first printed circuit board 324, and the first charging circuitry 371c receiving power from the wireless charging antenna 390 may be disposed on a second printed circuit board 370. According to an embodiment, as the first charging circuitry 371c for wireless charging and the second charging circuitry 325a for wired charging are dividedly disposed in different housings 310 and 320, the electronic device 300 may provide a structure that saves a mounting space in the electronic device 300.

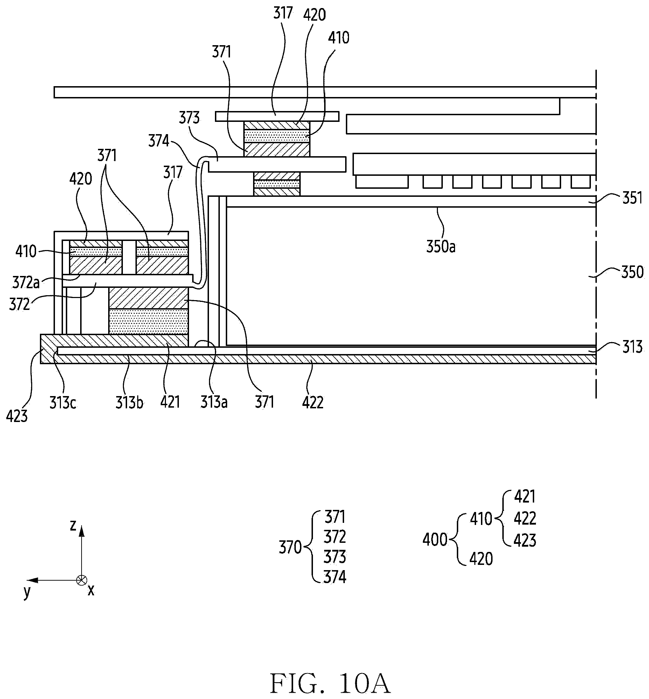

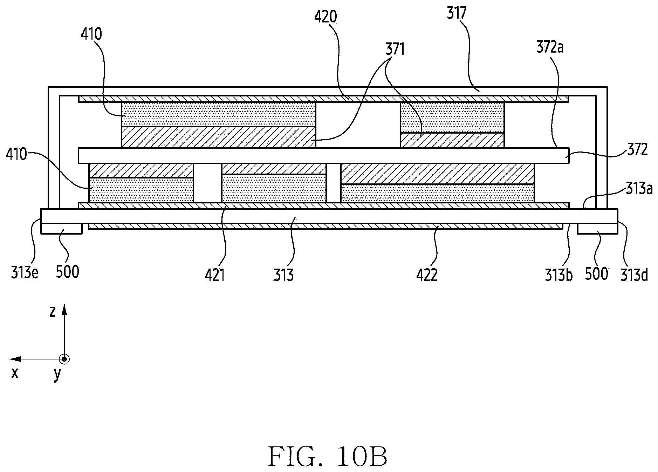

FIG. 10A is a cross-sectional view illustrating an example of an electronic device cut along C-C' of FIG. 6A, according to an embodiment, and FIG. 10B is a cross-sectional view illustrating an example of an electronic device cut along D-D' of FIG. 6A, according to an embodiment.

Since an electronic device 300 of FIGS. 10A and 10B may be the electronic device 300 to which a heat dissipation member 400 and friction prevention members 500 are added in the electronic device 300 of FIGS. 6A and 6B, an overlapping description will be omitted.

Referring to FIGS. 10A and 10B, according to an embodiment, one surface 372a of a first substrate 372 may be parallel to one surface 350a of a battery 350 on which a second substrate 373 is disposed. The one surface 372a of the first substrate 372 may face, for example, in a third direction (e.g., +z direction) perpendicular to a first direction.

According to an embodiment, the electronic device 300 may further include the heat dissipation member 400 and the friction prevention members 500. The heat dissipation member 400 may dissipate heat emitted from a plurality of electronic components 371 disposed on the second printed circuit board 370 to the outside of the second printed circuit board 370. For example, at least a portion of the heat dissipation member 400 may transfer heat emitted from the plurality of electronic components 371 to the frame cover 313 by contacting the plurality of electronic components 371 and the frame cover 313. According to an embodiment, the heat dissipation member 400 may contact a bracket 317. For example, the heat dissipation member 400 may be interposed between the bracket 317 and the second printed circuit board 370. As the heat dissipation member 400 contacts the bracket 317, heat emitted from the plurality of electronic components 371 may be transferred to the frame cover 313 and the bracket 317. According to an embodiment, the heat dissipation member 400 may be disposed on the first substrate 372 and the second substrate 373 of the second printed circuit board 370.

According to an embodiment, the heat dissipation member 400 may include a first heat dissipation member 410 disposed on the second printed circuit board 370 and a second heat dissipation member 420 disposed on the first heat dissipation member 410 and at least a portion thereof contacting the frame cover 313. The first heat dissipation member 410 may be disposed on the plurality of electronic components 371 of the second printed circuit board 370. According to an embodiment, the first heat dissipation member 410 may compensate for a height difference between the plurality of electronic components 371. For example, in case that the heights protruding from the second printed circuit board 370 of the plurality of electronic components 371 are different from each other, a thickness of the first heat dissipation member 410 disposed between each of the plurality of electronic components 371 may be different from each other. The first heat dissipation member 410 may include, for example, graphite, but is not limited thereto, and may include another material having thickness and flexibility and having high thermal conductivity.

According to an embodiment, the second heat dissipation member 420 may be disposed on the first heat dissipation member 410. The second heat dissipation member 420 may be in contact with the first heat dissipation member 410 and the bracket 317, by being interposed between the first heat dissipation member 410 and the bracket 317. According to an embodiment, the second heat dissipation member 420 may include a thermal interface material (TIM) as a material. For example, the second heat dissipation member 420 may be at least one of TIM SHEET, TIM TAPE, and NANO TIM, but is not limited thereto.

According to an embodiment, the second heat dissipation member 420 may extend from one surface 313a of the frame cover 313 to another surface 313b of the frame cover 313 opposing the one surface 313a of the frame cover 313. For example, the second heat dissipation member 420 may extend from a second recess 316 in which the first substrate 372 is disposed, and may extend to the other surface 313b of the frame cover 313. According to an embodiment, the second heat dissipation member 420 may include a first portion 421 contacting the one surface 313a of the frame cover 313 on which the second printed circuit board 370 is disposed, a second portion 422 contacting the other surface 313b of the frame cover 313, and a third portion 423 connecting the first portion 421 and the second portion 422. For example, the first portion 421 may extend in the first direction (+y direction) while contacting the one surface 313a of the frame cover 313. The second portion 422 may extend in a second direction (-y direction) while contacting the other surface 313b of the frame cover 313. The third portion 423 may connect the first portion 421 and the second portion 422 while contacting a lateral surface 313c of the frame cover 313 facing the first direction. For example, the lateral surface 313c of the frame cover 313 may be disposed between the one surface 313a of the frame cover 313 and the other surface 313b of the frame cover 313, and may be perpendicular to the one surface 313a of the frame cover 313 and the other surface 313b of the frame cover 313.

The friction prevention members 500 may protect the frame cover 313 from a front cover 321, by being disposed on the other surface 313b of the frame cover 313. According to an embodiment, the friction prevention members 500 may be attached to each of peripheries 313d and 313e opposing each other, among peripheries of the other surface 313b of the frame cover 313. For example, the peripheries 313d and 313e of the frame cover 313 may be spaced apart from each other with the first substrate 372 interposed therebetween. As the friction prevention members 500 are disposed by being spaced apart from the peripheries 313d and 313e of the frame cover 313, the second portion 422 may be disposed between the friction prevention members 500.

According to an embodiment, heat emitted from the plurality of electronic components 371 may be discharged to the frame cover 313 or the bracket 317 through the first heat dissipation member 410 and the second heat dissipation member 420. For example, the heat emitted from the plurality of electronic components 371 may move sequentially along the first portion 421 on the one surface 313a of the frame cover 313, the second portion 422 of the lateral surface 313c of the frame cover 313, and the third portion 423 of the other surface 313b of the frame cover 313. Since the frame cover 313 may be made of a material (e.g., aluminum) having high thermal conductivity, heat generated from the plurality of electronic components 371 may be effectively dissipated. For another example, the heat emitted from the plurality of electronic components 371 may pass through the first heat dissipation member 410 and the second heat dissipation member 420 and may be transferred to the bracket 317. Since the bracket 317 may be made of the material having high thermal conductivity (e.g., stainless steel), the heat generated from the plurality of electronic components 371 may be effectively dissipated.

As described above, according to one example, the electronic device 300 may provide a structure that efficiently dissipates the heat emitted from the plurality of electronic components 371 to the frame cover 313 and/or the bracket 317 by including the heat dissipation member 400. According to an embodiment, the electronic device 300 may provide a structure that increases a life of the frame cover 313 by including friction prevention members 500 that protect the other surface 313b of the frame cover 313.

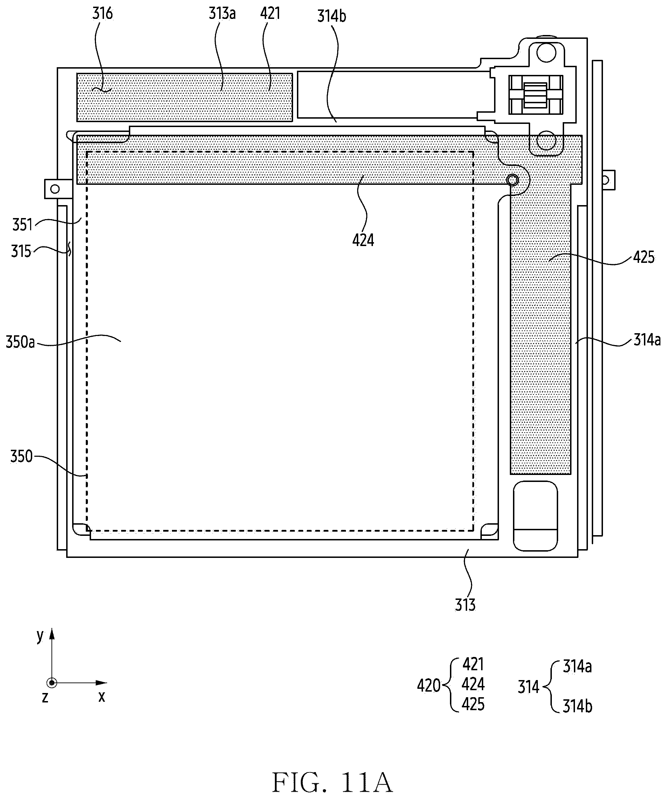

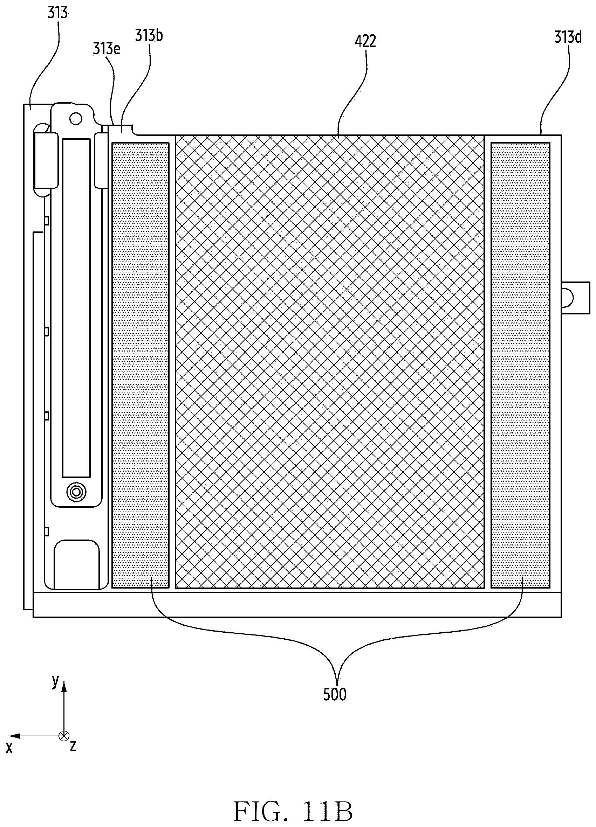

FIG. 11A is a front view of a frame cover of an electronic device according to an embodiment, and FIG. 11B is a rear view of a frame cover of an electronic device according to an embodiment.

Referring to FIGS. 11A and 11B, according to an embodiment, a second heat dissipation member 420 may extend toward a first partition wall 314a among partition walls 314 of a frame cover 313 on one surface 350a of a battery 350. For example, the second heat dissipation member 420 may include a fourth portion 424 crossing a battery plate 351 on the battery plate 351, and a fifth portion 425 connected to the fourth portion 424 and extending along the first partition wall 314a. For example, the fourth portion 424 may be in contact with the first partition wall 314a by extending along a second partition wall 314b in a fourth direction (e.g., +x direction) perpendicular to a first direction (+y direction) on the battery plate 351. The fifth portion 425 may extend in a second direction (e.g., -y direction) while contacting the first partition wall 314a. Since a rack gear (e.g., a rack gear 362 of FIGS. 4A and 4B) is accommodated, the first partition wall 314a may have a relatively large area. The second heat dissipation member 420 may efficiently dissipate heat by extending to the first partition wall 314a having the relatively large area.

According to an embodiment, the second heat dissipation member 420 may be disposed in a second recess 316. For example, a first portion 421 of the second heat dissipation member 420 may be in contact with one surface 313a of the frame cover 313 in the second recess 316. The second heat dissipation member 420 may extend from the one surface 313a of the frame cover 313 to another surface 313b of the frame cover 313. Friction prevention members 500 may be spaced apart from each other on the other surface 313b of the frame cover 313. For example, the friction prevention members 500 may be spaced apart from each other along the fourth direction (e.g., +x direction), and may be attached to each of the peripheries 313d and 313e opposing each other, among the peripheries of the other surface 313b of the frame cover 313. Since an area of the other surface 313b of the frame cover 313 is larger than an area of the second recess 316, as the second heat dissipation member 420 extends from the second recess 316 to the other surface 313b of the frame cover 313, the heat may be efficiently dissipated.

As described above, an electronic device (e.g., an electronic device 300 of FIG. 3A) according to an embodiment may provide a structure capable of efficiently dissipating the heat by disposing the second heat dissipation member 420 on the other surface 313b of the first partition wall 314a and the frame cover 313 having the relatively large area.

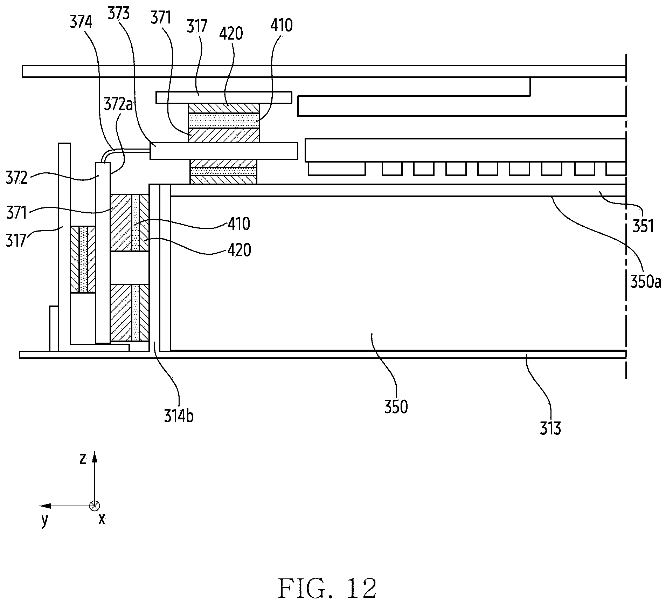

FIG. 12 is a cross-sectional view illustrating another example of an electronic device cut along C-C' of FIG. 6A, according to an embodiment.

Since an electronic device 300 of FIG. 12 may be the electronic device 300 in which a disposition structure of a first substrate 372 has been changed from the electronic device 300 of FIG. 10A, an overlapping description will be omitted.

Referring to FIG. 12, according to an embodiment, one surface 372a of the first substrate 372 may be perpendicular to one surface 350a of a battery 350 on which a second substrate 373 is disposed. The one surface 372a of the first substrate 372 may face, for example, a second direction (e.g., -y direction). A plurality of electronic components 371 may be disposed on the one surface 372a of the first substrate 372. The one surface 372a of the first substrate 372 on which the plurality of electronic components 371 are disposed may extend longer than other surfaces of the first substrate 372 perpendicular to the one surface 372a of the first substrate 372. Since the one surface 372a of the first substrate 372 is extended long, in case that the one surface 372a of the first substrate 372 is disposed perpendicular to the one surface 350a of the battery 350, a mounting space in the electronic device 300 may be saved compared to the case that the one surface 372a of the first substrate 372 is disposed parallel to the one surface 350a of the battery 350.

As described above, according to an embodiment, as the one surface 372a of the first substrate 372 is perpendicularly disposed on the one surface 350a of the battery 350, the electronic device 300 may provide a structure in which a mounting space in the electronic device 300 is saved.

An electronic device (e.g., an electronic device 300 of FIGS. 3A and 3B) according to an embodiment may comprise a first housing (e.g., a first housing 310 of FIGS. 3A and 3B), a second housing (e.g., a second housing 320 of FIGS. 3A and 3B) coupled to the first housing, so as to be extractable from the first housing or insertable into the first housing, and a display (e.g., a display 330 of FIGS. 3A and 3B) coupled to the second housing and expandable or reduceable according to the movement of the second housing. An electronic device according to an embodiment may include a second printed circuit board (e.g., a second printed circuit board 370 of FIGS. 5A and 5B), disposed in the first housing, a first printed circuit board (e.g., a first printed circuit board 324 of FIGS. 5A and 5B) disposed in the second housing, a battery (e.g., a battery 350 of FIGS. 5A and 5B) including a first lateral surface (e.g., a first lateral surface 352 of FIGS. 5A and 5B) disposed in the first housing and facing the second printed circuit board and a second lateral surface (e.g., a second lateral surface 353 of FIGS. 5A and 5B) opposing the first periphery, and a motor (e.g., a motor 361 of FIGS. 5A and 5B) disposed in the first housing to be adjacent to the first lateral surface among the first lateral surface and the second lateral surface and providing driving force to the second housing. According to an embodiment, the second printed circuit board may include the motor, power management circuitry electrically connected to the battery, and motor driving circuitry configured to drive the motor based on the power supplied from the power management circuitry, and may face to one end of the motor.

According to an embodiment, the electronic device may further include a wireless charging antenna (e.g., a wireless charging antenna 390 of FIGS. 7A and 7B) disposed in the first housing so as to be corresponded to the second printed circuit board. According to an embodiment, the power management circuitry may include first charging circuitry (e.g., wireless charging circuitry 371c of FIG. 8) configured to transmit power supplied from the wireless charging antenna to the battery.

According to an embodiment, the second housing may include a connector hole configured to receive power supplied from the outside of the electronic device. According to an embodiment, the first printed circuit board may include second charging circuitry configured to transmit power supplied from the connector hole to the battery, and may include second power management circuitry distinguished from the first power management circuitry, which is the power management circuitry.

According to an embodiment, the electronic device may further include a pinion gear (e.g., a pinion gear 362 of FIGS. 4A and 4B) rotatably coupled to the motor and a rack gear (e.g., a rack gear 363 of FIGS. 4A and 4B) capable of linear reciprocating with respect to the first housing according to rotation of the pinion gear by being disposed in the second housing and being engaged with the pinion gear.

According to an embodiment, the second printed circuit board may further include motor driving circuitry (e.g., motor driving circuitry 364 of FIGS. 5A and 5B) electrically connected to the motor and the power management circuitry.

According to an embodiment, the power management circuitry may include a plurality of electronic components (e.g., a plurality of electronic components 371 of FIGS. 5A and 5B). According to an embodiment, the first printed circuit board may further include a first substrate (e.g., a first substrate 372 of FIG. 6A and FIG. 6B) disposed in one area of the first housing closer to a first periphery among the first periphery and a second periphery, and on which a portion (e.g., a portion of a plurality of electronic components 371 of FIGS. 6A and 6B) of the plurality of electronic components are disposed, a second substrate (e.g., a second substrate 373 of 6A and 6B) spaced apart from the first substrate and on which another portion (e.g., another portion 371b of a plurality of electronic components 371 of 6A and 6B) of the plurality of electronic components 371 is disposed, and a connecting portion (e.g., a connecting portion 374 of FIGS. 6A and 6B) extending from the first substrate to the second substrate.

According to an embodiment, the first housing may include a first recess (e.g., a first recess 315 of FIGS. 5A and 5B) accommodating the battery, and a second recess (a second recess 316 of FIGS. 5A and 5B) spaced apart from the first recess with a partition wall (e.g., a second partition wall 314b of FIGS. 5A and 5B) included in the first housing interposed therebetween.

According to an embodiment, a distance from one surface (e.g., one surface 313a of a frame cover 313 of FIGS. 5A and 5B) of the first housing to the second substrate may be greater than a distance from the one surface of the first housing to the first substrate.

According to an embodiment, one surface (e.g., one surface 372a of the first substrate 372 of FIGS. 10A and 10B) of the first substrate may be parallel to one surface of the second substrate.

According to an embodiment, one surface (e.g., one surface 372a of the first substrate 372 of FIG. 12) of the first substrate may be perpendicular to one surface of the second substrate.

According to an embodiment, the other portion of the plurality of electronic components may have a first heat emission rate, and the portion of the plurality of electronic components may have a second heat emission rate higher than the first heat emission rate.

According to an embodiment, the portion of the plurality of electronic components may include charging circuitry, and the other portion of the plurality of electronic components may include switching circuitry.

According to an embodiment, the first housing may include a frame cover (e.g., a frame cover 313 of FIGS. 4A and 4B) surrounding the battery and the second printed circuit board, and a book cover (e.g., a book covers 311 of FIGS. 3A and 3B) protecting the frame cover by surrounding the frame cover.

According to an embodiment, the book cover may include a through hole (e.g., a through hole 311c of FIGS. 7A and 7B) corresponding to at least a portion of the second printed circuit board.

According to an embodiment, the first housing may further include a bracket (e.g., a bracket 317 of FIGS. 6A and 6B) coupled to the frame cover to support the second printed circuit board in the first housing.

According to an embodiment, the electronic device may further include a first heat dissipation member (e.g., a first heat dissipation member 410 of FIGS. 10A and 10B) disposed on a plurality of electronic components (e.g., a plurality of electronic components 371 of FIGS. 5A and 5B) included in the second printed circuit board, and a second heat dissipation member (e.g., the second heat dissipation member 420 of FIGS. 10A and 10B) disposed on the first heat dissipation member and at least a portion of the second heat dissipation member extends to the frame cover.

According to an embodiment, the second heat dissipation member may include a first portion (a first portion 421 of FIGS. 10A and 10B) in contact with one surface (e.g., one surface 313a of the frame cover 313 of FIGS. 5A and 5B) of the frame cover on which the battery is disposed, a second portion (a second portion 422 of FIGS. 10A and 10B) in contact with another surface (e.g., another surface 313b of the frame cover 313 of FIGS. 4A and 4B) of the frame cover facing a direction opposite to the direction in which the one surface of the frame cover faces, a third portion (e.g., a third portion 423 of FIG. 10A and 10B) in contact with a lateral surface (a lateral surface 313c of the frame cover 313 of FIG. 10A and 10B) of the frame cover.

According to an embodiment, the electronic device may further include friction prevention members (e.g., a friction prevention member 500 of FIG. 10B) in contact with each of the peripheries (e.g., peripheries 313d and 313e of FIG. 10B) opposing each other, among the peripheries of the other surface of the frame cover. According to an embodiment, the second portion may be interposed between the friction preventing members.

According to an embodiment, the electronic device may further include a battery plate (e.g., a battery plate 351 of FIG. 4A) covering at least a portion of the battery and partially interposed between the second printed circuit board and the battery. According to an embodiment, the second heat dissipation member may include a fourth portion (e.g., a fourth portion 424 of FIG. 11A) extending across the battery on the one surface of the battery and contacting the partition wall (e.g., the second partition wall 314b of FIGS. 5A and 5B) of the frame cover surrounding the battery, and a fifth portion (e.g., a fifth portion 425 of FIG. 11A) extending along the partition wall in a direction perpendicular to a direction in which the fourth portion extends.

According to an embodiment, the first printed circuit board may include a processor (e.g., a processor 120 of FIG. 1) operatively coupled to the battery.

According to an embodiment, the second housing may include a front cover (e.g., a front cover 321 of FIG. 4A) capable of linear reciprocating with respect to the first housing and accommodating the first printed circuit board, and a rear cover (e.g., a rear cover 322 of FIG. 4A) coupled to the front cover accommodating the first printed circuit board and movable together with the front cover.

According to an embodiment, the electronic device may further include a flexible printed circuit board (e.g., e.g., a flexible printed circuit board 380 of FIGS. 5A and 5B) electrically connecting the second printed circuit board and the first printed circuit board, folded in a first state in which the second housing is inserted into the first housing, and unfolded in a second state in which the second housing is extracted from the first housing.

The electronic device according to one embodiment (e.g., the electronic device 300 of FIGS. 3A and 3B) may include a first housing (e.g., a first housing 310 of FIGS. 3A and 3B), a second housing (e.g., a second housing 320 of FIGS. 3A and 3B) coupled to the first housing so as to be slidable with respect to the first housing, a display (e.g., a display 330 of FIGS. 3A and 3B) disposed on the second housing and capable of being inserted into the first housing or capable of being extracted from the first housing according to movement of the second housing. The electronic device according to an embodiment may include a second printed circuit board (e.g., a second printed circuit board 370 of FIGS. 5A and 5B) disposed in the first housing, a first printed circuit board (e.g., a first printed circuit board 324 of FIGS. 5A and 5B) disposed in the second housing, a battery (e.g., the battery 350 of FIGS. 5A and 5B) disposed in the first housing and including a first lateral surface (e.g., a first lateral surface 352 of FIGS. 5A and 5B) facing the first printed circuit board and a second lateral surface (e.g., a second lateral surface 353 of FIGS. 5A and 5B) facing the first lateral surface, power management circuitry disposed on the second printed circuit board and including a plurality of electronic components (e.g., a plurality of electronic components 371 of FIGS. 5A and 5B). According to an embodiment, the second printed circuit board may include a first substrate (e.g., a first substrate 372 of FIGS. 6A and 6B) on which a portion (e.g., a portion 371a of the plurality of electronic components 371 of FIGS. 6A and 6B) of the plurality of electronic components are disposed and opposing the lateral surface, a second substrate (e.g., a second substrate 373 of FIGS. 6A and 6B) disposed on one surface of the battery and on which another portion of the plurality of electronic components is disposed, and a connecting portion (e.g., a connecting portion 374 of FIGS. 6A and 6B) connecting the first substrate and the second substrate, and may be adjacent to the first lateral surface among the first lateral surface and the second lateral surface.

According to an embodiment, the electronic device may further include a motor (e.g., a motor 361 of FIG. 4A) disposed in the first housing adjacent to the first periphery among the first periphery and the second periphery and providing driving force to the second housing.

According to an embodiment, the electronic device may further include a pinion gear (e.g., a pinion gear 362 of FIGS. 4A and 4B) rotatably coupled to the motor and a rack gear (e.g., a rack gear 363 of FIGS. 4A and 4B) relatively moving with respect to the first housing according to the rotation of the pinion gear, by being disposed in the second housing and engaged with the pinion gear.

According to an embodiment, the electronic device may further include a wireless charging antenna (e.g., a wireless charging antenna 390 of FIGS. 7A and 7B) disposed on the one surface of the battery. According to an embodiment, the power management circuitry may include first charging circuitry (e.g., first charging circuitry 371c of FIG. 8) configured to transmit power supplied from the wireless charging antenna to the battery.

According to an embodiment, a heat emission rate of the other portion of the plurality of electronic components may be lower than a heat emission rate of the portion of the plurality of electronic components.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101, 300) comprising:
a first housing (310);
a second housing (320) slidably coupled to the first housing;
a flexible display (330), supported by the first housing and the second housing, including a portion (330b) rolled into the first housing when the second housing is slid-in with respect to the first housing;
a first printed circuit board (324) disposed in the second housing;
a second printed circuit board (370) disposed in the first housing;
a flexible printed circuit board (380) electrically connecting the first printed circuit board and the second printed circuit board and configured to be folded or unfolded according to a sliding movement of the second housing;
a motor (361) disposed in the first housing and configured to provide driving force for the sliding movement of the second housing;
a battery (189, 350) disposed in the first housing and configured to supply power to the motor;
motor driving circuitry (364) disposed on the second printed circuit board; and
power management circuitry (371), disposed on the second printed circuit board, electrically connected to the battery disposed in the first housing, and configured to:
obtain power from the battery, and
using the power from the battery:
provide power through the flexible printed circuit board to the first printed circuit board, and
provide power to the motor driving circuitry,
wherein the motor driving circuitry configured to drive the motor using the power provided from the power management circuitry to the motor driving circuitry.

2. The electronic device of claim 1, wherein the second printed circuit board is closer to a first lateral surface (352) among the first lateral surface of the battery facing the first printed circuit board and a second lateral surface (353) of the battery opposing the first lateral surface.

3. The electronic device of any one of claim 1 and claim 2, further comprising:
a wireless charging antenna (390) disposed on a surface (350a) of the battery; and
wherein the second printed circuit board includes first charging circuitry (371c) configured to transmit power supplied from the wireless charging antenna to the battery.

4. The electronic device of any one of claims 1 to 3, wherein the second housing includes a connector hole (326) configured to receive power supplied from external of the electronic device, and
wherein the power management circuitry is first power management circuitry and the second printed circuit board includes second power management circuitry including second charging circuitry (325a) configured to transmit power supplied from the connect hole to the battery and second power management circuitry is distinct from the first power management circuitry.

5. The electronic device of any one of claims 1 to 4, further comprising a pinion gear (362) rotatably coupled to the motor and disposed at another end of the motor; and
a rack gear (363) disposed in the second housing and moved relative to the first housing according to rotation of the pinion gear, in response to engagement with the pinion gear.

6. The electronic device of any one of claims 1 to 5, wherein the power management circuitry includes a plurality of electronic components (371), and
wherein the second printed circuit board further includes:
a first substrate (372) on which a portion of the plurality of the electronic components is disposed, the first substrate is spaced apart from the battery;
a second substrate (373) on which another portion of the plurality of the electronic components is disposed, the second substrate is disposed on a surface of the battery; and
a connecting portion (374) connecting the first substrate and the second substrate.

7. The electronic device of claim 6, wherein the first housing includes:
a first recess (315) accommodating the battery; and
a second recess (316) accommodating the first substrate.

8. The electronic device of any one of claim 6 and claim 7, wherein the second substrate has a step with respect to the first substrate.

9. The electronic device of any one of claims 6 to 8, wherein a surface of the first substrate is parallel to the surface of the battery on which the second substrate is disposed.

10. The electronic device of any one of claims 6 to 9, wherein a surface of the first substrate is perpendicular to the surface of the battery on which the second substrate is disposed.

11. The electronic device of any one of claims 6 to 10, wherein the other portion of the plurality of the electronic components (371b) have lower heat emission than the portion of the plurality of the electronic components.

12. The electronic device of any one of claims 6 to 11, wherein the portion of the plurality of the electronic components include charging circuitry, and
wherein the other portion of the plurality of the electronic components include switching circuitry.

13. The electronic device of any one of claims 1 to 12, wherein the first housing includes:
a frame cover (313) accommodating the battery and the second printed circuit board;
a first heat dissipation member (410) disposed on the second printed circuit board; and
a second heat dissipation member (420) disposed on the first heat dissipation member, at least part of the second heat dissipation member in contact with the frame cover.

14. The electronic device of claim 13, wherein the first housing further includes a bracket (317) supporting the second printed circuit board by coupling to the frame cover in the first housing.

15. The electronic device of any one of claim 13 and claim 14, wherein the second heat dissipation member includes:
a first portion in contact with a surface of the frame cover on which the second printed circuit board is disposed;
a second portion in contact with another surface of the frame cover opposite to the surface of the frame cover; and
a third portion connecting the first portion and the second portion.

## Patentansprüche

1. Elektronische Vorrichtung (101, 300), umfassend:
ein erstes Gehäuse (310);
ein zweites Gehäuse (320), das verschiebbar an das erste Gehäuse gekoppelt ist;
eine flexible Anzeige (330), die durch das erste Gehäuse und das zweite Gehäuse getragen wird, einen Abschnitt (330b) einschließend, der in das erste Gehäuse gerollt ist, wenn das zweite Gehäuse in Bezug auf das erste Gehäuse eingeschoben ist;
eine erste gedruckte Leiterplatte (324), die in dem zweiten Gehäuse angeordnet ist;
eine zweite gedruckte Leiterplatte (370), die in dem ersten Gehäuse angeordnet ist;
eine flexible gedruckte Leiterplatte (380), die die erste gedruckte Leiterplatte und die zweite gedruckte Leiterplatte elektrisch verbindet und dazu konfiguriert ist, gemäß einer Schiebebewegung des zweiten Gehäuses gefaltet oder entfaltet zu werden;
einen Motor (361), der in dem ersten Gehäuse angeordnet ist und dazu konfiguriert ist, eine Antriebskraft für die Schiebebewegung des zweiten Gehäuses bereitzustellen;
eine Batterie (189, 350), die in dem ersten Gehäuse angeordnet ist und dazu konfiguriert ist, dem Motor Leistung zuzuführen;
Motorantriebsschaltungen (364), die auf der zweiten gedruckten Leiterplatte angeordnet sind; und
Leistungsverwaltungsschaltungen (371), die auf der zweiten gedruckten Leiterplatte angeordnet sind, elektrisch mit der Batterie verbunden sind, die in dem ersten Gehäuse angeordnet ist, und zu Folgendem konfiguriert sind:
Leistung von der Batterie zu erhalten, und
Verwendung der Leistung von der Batterie:
Bereitstellen von Leistung durch die flexible gedruckte Leiterplatte an die erste gedruckte Leiterplatte, und
Bereitstellen von Leistung an die Motorantriebsschaltungen,
wobei die Motorantriebsschaltungen dazu konfiguriert sind, den Motor unter Verwendung der Leistung anzutreiben, die von den Leistungsverwaltungsschaltungen an die Motorantriebsschaltungen bereitgestellt wird.

2. Elektronische Vorrichtung nach Anspruch 1, wobei die zweite gedruckte Leiterplatte näher an einer ersten seitlichen Oberfläche (352) unter der ersten seitlichen Oberfläche der Batterie, die der ersten gedruckten Leiterplatte zugewandt ist, und einer zweiten seitlichen Oberfläche (353) der Batterie ist, die der ersten seitlichen Oberfläche gegenüberliegt.

3. Elektronische Vorrichtung nach einem der Anspruch 1 und Anspruch 2, ferner umfassend:
eine drahtlose Ladeantenne (390), die auf einer Oberfläche (350a) der Batterie angeordnet ist; und
wobei die zweite gedruckte Leiterplatte erste Ladeschaltungen (371c) einschließt, die dazu konfiguriert sind, Leistung, die von der drahtlosen Ladeantenne zugeführt wird, an die Batterie zu übertragen.

4. Elektronische Vorrichtung nach einem der Ansprüche 1 bis 3, wobei das zweite Gehäuse ein Verbinderloch (326) einschließt, das dazu konfiguriert ist, Leistung zu empfangen, die von außerhalb der elektronischen Vorrichtung zugeführt wird, und
wobei die Leistungsverwaltungsschaltungen erste Leistungsverwaltungsschaltungen sind und die zweite gedruckte Leiterplatte zweite Leistungsverwaltungsschaltungen einschließt, die zweite Ladeschaltungen (325a) einschließen, die dazu konfiguriert sind, von dem Verbindungsloch zugeführte Leistung an die Batterie zu übertragen, und zweite Leistungsverwaltungsschaltungen sich von ersten Leistungsverwaltungsschaltungen unterscheiden.

5. Elektronische Vorrichtung nach einem der Ansprüche 1 bis 4, ferner umfassend ein Ritzel (362), das drehbar an den Motor gekoppelt und an einem anderen Ende des Motors angeordnet ist; und
ein Zahnstangenzahnrad (363), das in dem zweiten Gehäuse angeordnet ist und relativ zu dem ersten Gehäuse gemäß einer Drehung des Ritzels als Reaktion auf einen Eingriff mit dem Ritzel bewegt wird.

6. Elektronische Vorrichtung nach einem der Ansprüche 1 bis 5, wobei die Leistungsverwaltungsschaltungen eine Vielzahl von elektronischen Komponenten (371) einschließt und
wobei die zweite gedruckte Leiterplatte ferner Folgendes einschließt:
ein erstes Substrat (372), auf welchem ein Abschnitt der Vielzahl der elektronischen Komponenten angeordnet ist, wobei das erste Substrat von der Batterie beabstandet ist;
ein zweites Substrat (373), auf welchem ein anderer Abschnitt der Vielzahl von elektronischen Komponenten angeordnet ist, wobei das zweite Substrat auf einer Oberfläche der Batterie angeordnet ist; und
einen Verbindungsabschnitt (374), der das erste Substrat und das zweite Substrat verbindet.

7. Elektronische Vorrichtung nach Anspruch 6, wobei das erste Gehäuse Folgendes einschließt:
eine erste Aussparung (315), die die Batterie aufnimmt; und
eine zweite Aussparung (316), die das erste Substrat aufnimmt.

8. Elektronische Vorrichtung nach einem der Anspruch 6 und Anspruch 7, wobei das zweite Substrat eine Stufe in Bezug auf das erste Substrat aufweist.

9. Elektronische Vorrichtung nach einem der Ansprüche 6 bis 8, wobei eine Oberfläche des ersten Substrats parallel zu der Oberfläche der Batterie ist, auf welcher das zweite Substrat angeordnet ist.

10. Elektronische Vorrichtung nach einem der Ansprüche 6 bis 9, wobei eine Oberfläche des ersten Substrats senkrecht zu der Oberfläche der Batterie ist, auf welcher das zweite Substrat angeordnet ist.

11. Elektronische Vorrichtung nach einem der Ansprüche 6 bis 10, wobei der andere Abschnitt der Vielzahl der elektronischen Komponenten (371b) eine niedrigere Wärmeabgabe als der Abschnitt der Vielzahl der elektronischen Komponenten aufweist.

12. Elektronische Vorrichtung nach einem der Ansprüche 6 bis 11, wobei der Abschnitt der Vielzahl der elektronischen Komponenten Ladeschaltungen einschließt, und
wobei der andere Abschnitt der Vielzahl der elektronischen Komponenten Umschaltschaltungen einschließt.

13. Elektronische Vorrichtung nach einem der Ansprüche 1 bis 12, wobei das erste Gehäuse Folgendes einschließt:
eine Rahmenabdeckung (313), die die Batterie und die zweite gedruckte Leiterplatte aufnimmt;
ein erstes Wärmeableitungselement (410), das auf der zweiten gedruckten Leiterplatte angeordnet ist; und
ein zweites Wärmeableitungselement (420), das auf dem ersten Wärmeableitungselement angeordnet ist, wobei zumindest ein Teil des zweiten Wärmeableitungselements in Kontakt mit der Rahmenabdeckung ist.

14. Elektronische Vorrichtung nach Anspruch 13, wobei das erste Gehäuse ferner eine Halterung (317) einschließt, die die zweite gedruckte Leiterplatte durch Koppeln an die Rahmenabdeckung in dem ersten Gehäuse trägt.

15. Elektronische Vorrichtung nach einem der Anspruch 13 und Anspruch 14, wobei das zweite Wärmeableitungselement Folgendes einschließt:
einen ersten Abschnitt in Kontakt mit einer Oberfläche der Rahmenabdeckung, auf welcher die zweite gedruckte Leiterplatte angeordnet ist;
einen zweiten Abschnitt, der mit einer anderen Oberfläche der Rahmenabdeckung, die der Oberfläche der Rahmenabdeckung gegenüberliegt, in Kontakt steht; und
einen dritten Abschnitt, der den ersten Abschnitt und den zweiten Abschnitt verbindet.

## Revendications

1. Dispositif électronique (101, 300) comprenant :
un premier boîtier (310) ;
un second boîtier (320) couplé de manière coulissante au premier boîtier ;
un affichage souple (330), supporté par le premier boîtier et le second boîtier, comprenant une portion (330b) enroulée dans le premier boîtier lorsque le second boîtier est coulissé vers l'intérieur par rapport au premier boîtier ;
une première carte de circuit imprimé (324) disposée dans le second boîtier ;
une seconde carte de circuit imprimé (370) disposée dans le premier boîtier ;
une carte de circuit imprimé souple (380) connectant électriquement la première carte de circuit imprimé et la seconde carte de circuit imprimé et configurée pour être pliée ou dépliée en fonction d'un mouvement de coulissement du second boîtier ;
un moteur (361) disposé dans le premier boîtier et configuré pour fournir une force d'entraînement pour le mouvement de coulissement du second boîtier ;
une batterie (189, 350) disposée dans le premier boîtier et configurée pour délivrer de la puissance au moteur ;
un circuit d'entraînement de moteur (364) disposé sur la seconde carte de circuit imprimé ; et
un circuit de gestion de la puissance (371), disposé sur la seconde carte de circuit imprimé, connecté électriquement à la batterie disposée dans le premier boîtier, et configuré pour :
obtenir de la puissance auprès de la batterie, et
à l'aide de la puissance provenant de la batterie :
délivrer de la puissance à travers la carte de circuit imprimé souple à la première carte de circuit imprimé, et
délivrer de la puissance au circuit d'entraînement de moteur,
dans lequel le circuit d'entraînement de moteur est configuré pour entraîner le moteur en utilisant la puissance délivrée par le circuit de gestion de la puissance au circuit d'entraînement de moteur.

2. Dispositif électronique selon la revendication 1, dans lequel la seconde carte de circuit imprimé est plus proche d'une première surface latérale (352) entre la première surface latérale de la batterie faisant face à la première carte de circuit imprimé et une seconde surface latérale (353) de la batterie faisant face à la première surface latérale.

3. Dispositif électronique selon l'une quelconque de la revendication 1 et la revendication 2, comprenant en outre :
une antenne de charge sans fil (390) disposée sur une surface (350a) de la batterie ; et
dans lequel la seconde carte de circuit imprimé comprend un premier circuit de charge (371c) configuré pour transmettre la puissance délivrée à partir de l'antenne de charge sans fil à la batterie.

4. Dispositif électronique selon l'une quelconque des revendications 1 à 3, dans lequel le second boîtier comprend un trou de connecteur (326) configuré pour recevoir la puissance délivrée à partir de l'extérieur du dispositif électronique, et
dans lequel le circuit de gestion de la puissance est un premier circuit de gestion de la puissance et la seconde carte de circuit imprimé comprend un second circuit de gestion de la puissance comprenant un second circuit de charge (325a) configuré pour transmettre la puissance délivrée à partir du trou de connexion à la batterie et le second circuit de gestion de la puissance est distinct du premier circuit de gestion de la puissance.

5. Dispositif électronique selon l'une quelconque des revendications 1 à 4, comprenant en outre un engrenage à pignons (362) couplé de manière rotative au moteur et disposé à une autre extrémité du moteur ; et
un engrenage à crémaillère (363) disposé dans le second boîtier et déplacé par rapport au premier boîtier en fonction de la rotation de l'engrenage à pignons, en réponse à une mise en prise avec l'engrenage à pignons.

6. Dispositif électronique selon l'une quelconque des revendications 1 à 5, dans lequel le circuit de gestion de la puissance comprend une pluralité de composants électroniques (371), et
dans lequel la seconde carte de circuit imprimé comprend en outre :
un premier substrat (372) sur lequel une portion de la pluralité de composants électroniques sont disposés, le premier substrat étant espacé de la batterie ;
un second substrat (373) sur lequel une autre portion de la pluralité des composants électroniques sont disposés, le second substrat étant disposé sur une surface de la batterie ; et
une portion de connexion (374) connectant le premier substrat et le second substrat.

7. Dispositif électronique selon la revendication 6, dans lequel le premier boîtier comprend :
un premier évidement (315) recevant la batterie ; et
un second évidement (316) recevant le premier substrat.

8. Dispositif électronique selon l'une quelconque de la revendication 6 et la revendication 7, dans lequel le second substrat présente une marche par rapport au premier substrat.

9. Dispositif électronique selon l'une quelconque des revendications 6 à 8, dans lequel une surface du premier substrat est parallèle à la surface de la batterie sur laquelle le second substrat est disposé.

10. Dispositif électronique selon l'une quelconque des revendications 6 à 9, dans lequel une surface du premier substrat est perpendiculaire à la surface de la batterie sur laquelle le second substrat est disposé.

11. Dispositif électronique selon l'une quelconque des revendications 6 à 10, dans lequel l'autre portion de la pluralité de composants électroniques (371b) ont une émission de chaleur inférieure à la portion de la pluralité de composants électroniques.

12. Dispositif électronique selon l'une quelconque des revendications 6 à 11, dans lequel la portion de la pluralité de composants électroniques comprennent un circuit de charge, et
dans lequel l'autre portion de la pluralité des composants électroniques comprennent un circuit de commutation.

13. Dispositif électronique selon l'une quelconque des revendications 1 à 12, dans lequel le premier boîtier comprend :
un capot de cadre (313) recevant la batterie et la seconde carte de circuit imprimé ;
un premier élément de dissipation de chaleur (410) disposé sur la seconde carte de circuit imprimé ; et
un second élément de dissipation de chaleur (420) disposé sur le premier élément de dissipation de chaleur, au moins une partie du second élément de dissipation de chaleur étant en contact avec le capot de cadre.

14. Dispositif électronique selon la revendication 13, dans lequel le premier boîtier comprend en outre un support (317) supportant la seconde carte de circuit imprimé par couplage au capot de cadre dans le premier boîtier.

15. Dispositif électronique selon l'une quelconque de la revendication 13 et la revendication **14,** dans lequel le second élément de dissipation de chaleur comprend :
une première portion en contact avec une surface du capot de cadre sur laquelle la seconde carte de circuit imprimé est disposée ;
une deuxième portion en contact avec une autre surface du capot de cadre opposée à la surface du capot de cadre ; et
une troisième portion reliant la première portion et la deuxième portion.
